(19) Europäisches Patentamt
European Patent Office
Office européen des brevets

(11) EP 3 832 390 A1

(12) EUROPEAN PATENT APPLICATION
published in accordance with Art. 153(4) EPC

(43) Date of publication:
**09.06.2021 Bulletin 2021/23**

(21) Application number: **19843810.3**

(22) Date of filing: **23.07.2019**

(51) Int Cl.:
*G03F 7/11 (2006.01)* *C08G 8/04 (2006.01)*
*G03F 7/20 (2006.01)* *G03F 7/039 (2006.01)*

(86) International application number:
**PCT/JP2019/028741**

(87) International publication number:
**WO 2020/026879 (06.02.2020 Gazette 2020/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **31.07.2018 JP 2018143710**

(71) Applicant: **MITSUBISHI GAS CHEMICAL COMPANY, INC.**
**Chiyoda-ku**
**Tokyo 100-8324 (JP)**

(72) Inventors:
- **OKADA, Yu**
  **Hiratsuka-shi, Kanagawa 254-0016 (JP)**
- **MAKINOSHIMA, Takashi**
  **Hiratsuka-shi, Kanagawa 254-0016 (JP)**
- **ECHIGO, Masatoshi**
  **Tokyo 100-8324 (JP)**

(74) Representative: **Müller-Boré & Partner Patentanwälte PartG mbB**
**Friedenheimer Brücke 21**
**80639 München (DE)**

(54) **UNDERLAYER FILM-FORMING COMPOSITION**

(57) An object of the present invention is to provide a useful underlayer film forming composition. The following underlayer film forming composition can solve the problem described above. An underlayer film forming composition comprising: a compound having a constituent unit represented by the following formula (1); and a solvent, wherein
the weight average molecular weight of the compound is 1,000 to 30,000 as the molecular weight in terms of polystyrene, and
the solubility of the compound in propylene glycol monomethyl ether acetate is 10% by mass at 23°C:

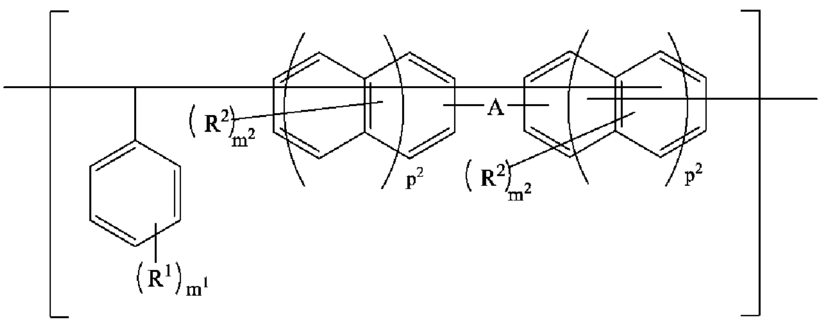

(1)

wherein
A is a single bond or a divalent group;
each $R^1$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group;
each $R^2$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a

EP 3 832 390 A1

thiol group, or a hydroxy group,
where at least one $R^2$ is a hydroxy group and/or a thiol group;
each $m^1$ is independently an integer of 0 to 5;
each $m^2$ is independently an integer of 0 to 8; and
each $p^2$ is independently an integer of 0 to 2.

## Description

Technical Field

The present invention relates to an underlayer film forming composition.

Background Art

In the production of semiconductor devices, fine processing is practiced by lithography using photoresist materials. In recent years, further miniaturization based on pattern rules has been demanded along with increase in the integration and speed of LSI (large scale integrated circuits). The light source for lithography used upon forming resist patterns has been shifted to ArF excimer laser (193 nm) having a shorter wavelength from KrF excimer laser (248 nm). The introduction of extreme ultraviolet (EUV, 13.5 nm) is also expected.
However, when the miniaturization of resist patterns proceeds, the problem of resolution or the problem of collapse of resist patterns after development arises. Therefore, resists have been desired to have a thinner film. However, if resists merely have a thinner film, it is difficult to obtain the film thicknesses of resist patterns sufficient for supporting material processing. Therefore, there has been a need for a process of preparing a resist underlayer film between a resist and a semiconductor supporting material to be processed, and imparting functions as a mask for supporting material processing to this resist underlayer film in addition to a resist pattern.
Various resist underlayer films for such a process are currently known. For example, in order to achieve a resist underlayer film for lithography having the selectivity of a dry etching rate smaller than that of resists, a resist underlayer film material comprising a polymer having a specific repeat unit has been suggested (see Patent Literature 1). Furthermore, in order to realize a resist underlayer film for lithography having the selectivity of a dry etching rate smaller than that of semiconductor supporting materials, a resist underlayer film material comprising a polymer prepared by copolymerizing a repeat unit of an acenaphthylene and a repeat unit having a substituted or unsubstituted hydroxy group has been suggested (see Patent Literature 2).
Meanwhile, as materials having high etching resistance for this kind of resist underlayer film, amorphous carbon underlayer films formed by chemical vapour deposition (CVD) using methane gas, ethane gas, acetylene gas, or the like as a raw material are well known. However, resist underlayer film materials that can form resist underlayer films by a wet process such as spin coating or screen printing have been demanded from the viewpoint of a process.
The present inventors have also proposed an underlayer film forming composition for lithography containing a compound having a specific structure and an organic solvent (see Patent Literature 3) as a material that is excellent in etching resistance, has high heat resistance, and is soluble in a solvent and applicable to a wet process.

Citation List

Patent Literature

Patent Literature 1: Japanese Patent Laid-Open No. 2004-271838
Patent Literature 2: Japanese Patent Laid-Open No. 2005-250434
Patent Literature 3: International Publication No. WO 2013/024779

Summary of Invention

Technical Problem

However, it is required for underlayer film forming compositions to satisfy high levels of solubility in organic solvents, etching resistance and resist pattern formability at the same time and to have higher heat resistance.
Then, it is an object of the present invention to provide a useful underlayer film forming composition.

Solution to Problem

The inventors have, as a result of devoted examinations to solve the problems described above, found out that a specific underlayer film forming composition is useful, and reached the present invention.
More specifically, the present invention is as follows.

[1] An underlayer film forming composition comprising:

a compound having a constituent unit represented by the following formula (1), and
a solvent, wherein
a weight average molecular weight of the compound is 1,000 to 30,000 as a molecular weight in terms of polystyrene, and
a solubility of the compound in propylene glycol monomethyl ether acetate is 10% by mass or more at 23°C:

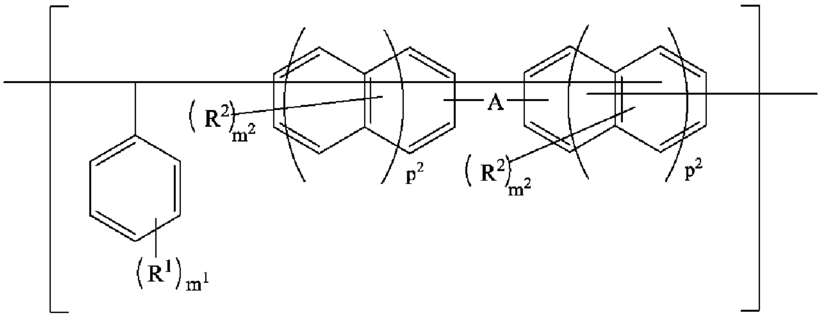

(1)

wherein
A is a single bond or a divalent group;
each $R^1$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group;
each $R^2$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group,
where at least one $R^2$ is a hydroxy group and/or a thiol group;
each $m^1$ is independently an integer of 0 to 5;
each $m^2$ is independently an integer of 0 to 8; and each $p^2$ is independently an integer of 0 to 2.

[2] The underlayer film forming composition according to [1], wherein the compound having a constituent unit represented by the formula (1) is a compound having a constituent unit represented by the following formula (1a) :

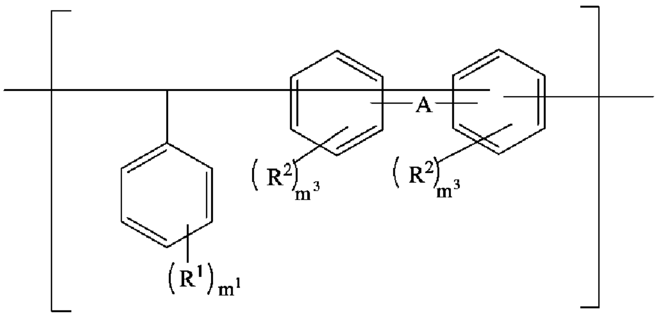

(1 a)

wherein
each $m^3$ is independently an integer of 0 to 4; and A, $R^1$, $R^2$, and $m^1$ are as defined above.
[3] The underlayer film forming composition according to [2], wherein the compound having a constituent unit represented by the formula (1a) is a compound having a constituent unit represented by the following formula (1b) :

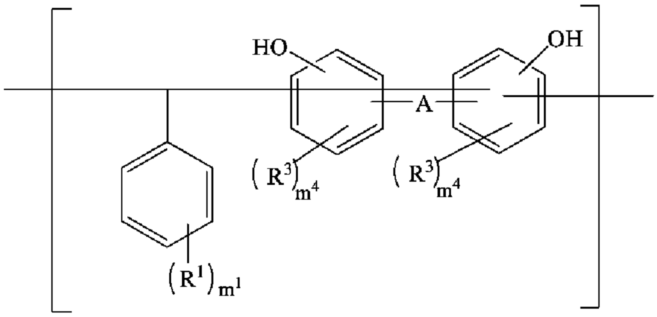

(1 b)

wherein

each $R^3$ is independently a linear, branched, or cyclic alkyl group having 1 to 10 carbon atoms, an aryl group having 6 to 10 carbon atoms, an alkenyl group having 2 to 10 carbon atoms, or an alkynyl group having 2 to 10 carbon atoms; each $m^4$ is independently an integer of 0 to 3; and A, $R^1$, and $m^1$ are as defined above.

[4] The underlayer film forming composition according to any of [1] to [3], wherein A is -S-, -O-, a linear, branched, or cyclic alkylene group having 1 to 10 carbon atoms, an arylene group having 6 to 10 carbon atoms, an alkenylene group having 2 to 10 carbon atoms, an alkynylene group having 2 to 10 carbon atoms, or a carbonyl group.

[5] The underlayer film forming composition according to any of [1] to [3], wherein A is -O-, a linear, branched, or cyclic alkylene group having 1 to 10 carbon atoms, or a carbonyl group.

[6] The underlayer film forming composition according to [3], wherein the compound having a constituent unit represented by the formula (1b) is a compound having a constituent unit selected from the following formulas (1b-1) to (1b-5) :

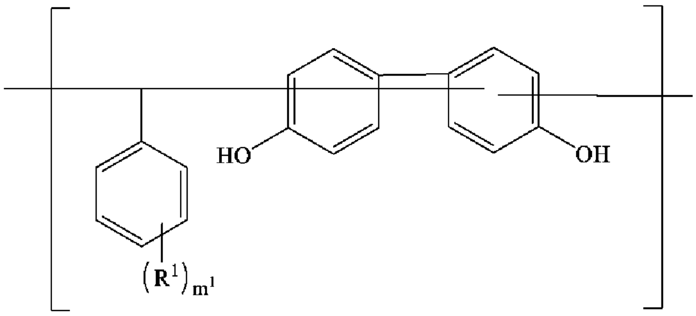

(1 b − 1)

wherein $R^1$ and $m^1$ are as defined above;

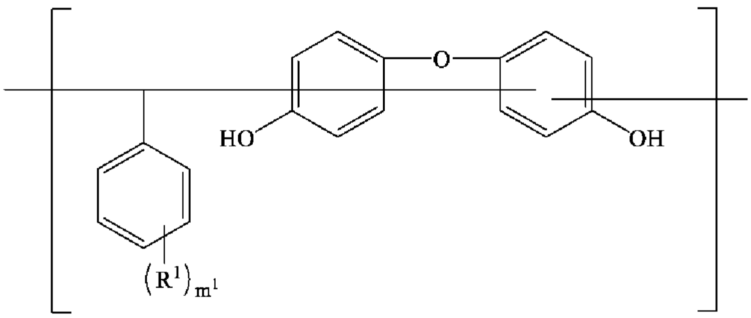

(1 b − 2)

wherein $R^1$ and $m^1$ are as defined above;

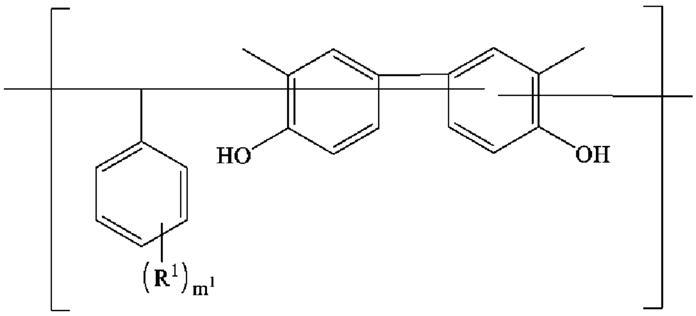

(1 b − 3)

wherein $R^1$ and $m^1$ are as defined above;

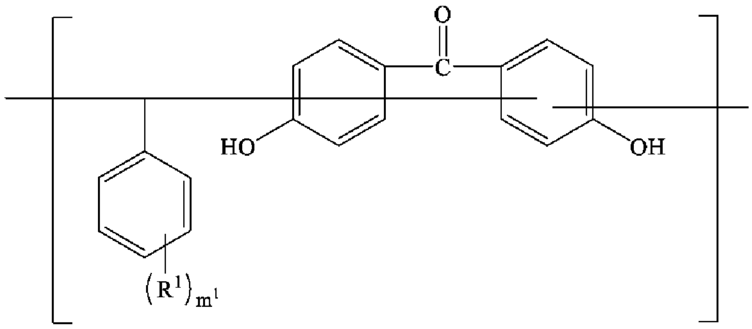

(1 b − 4)

wherein $R^1$ and $m^1$ are as defined above; and

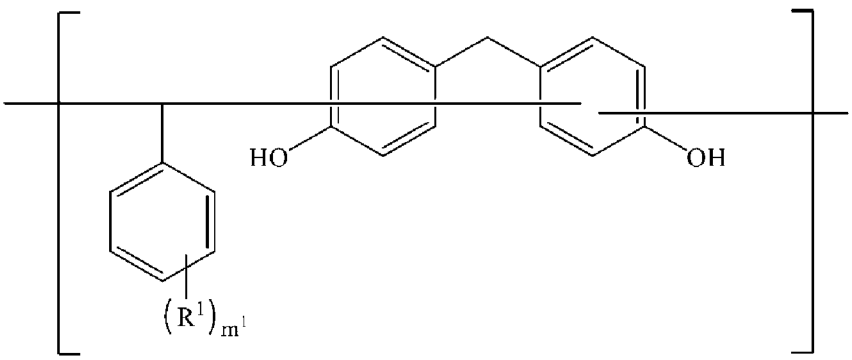

(1 b − 5)

wherein $R^1$ and $m^1$ are as defined above.

[7] The underlayer film forming composition according to any of [1] to [6], further comprising an acid generating agent.

[8] The underlayer film forming composition according to any of [1] to [7], further comprising a crosslinking agent.

[9] An underlayer film for lithography formed from the underlayer film forming composition according to any one of [1] to [8].

[10] A method for forming a resist pattern, comprising the steps of:

forming an underlayer film on a supporting material using the underlayer film forming composition according to any one of [1] to [8];
forming at least one photoresist layer on the underlayer film; and
irradiating a predetermined region of the photoresist layer with radiation for development.

[11] A method for forming a resist pattern, comprising the steps of:

forming an underlayer film on a supporting material using the underlayer film forming composition according to any one of [1] to [8];
forming an intermediate layer film on the underlayer film;

forming at least one photoresist layer on the intermediate layer film;
irradiating a predetermined region of the photoresist layer with radiation for development, thereby forming a resist pattern;
etching the intermediate layer film with the resist pattern as a mask;
etching the underlayer film with the obtained intermediate layer film pattern as a mask; and
etching the supporting material with the obtained underlayer film pattern as a mask, thereby forming a pattern on the supporting material.

[12] A resist permanent film formed from the underlayer film forming composition according to any one of [1] to [8].

Advantageous Effects of Invention

According to the present invention, a useful underlayer film forming composition can be provided.

Description of Embodiments

Hereinafter, an embodiment of the present invention will be described (hereinafter, referred to as the "present embodiment"). The embodiment described below is given merely for illustrating the present invention. The present invention is not limited only by this embodiment.

As an interpretation of structural formulae described in the present specification, for example, the case where a line indicating a bond to X is in contact with rings A to D as described below means that X may be bonded to any of the rings A to D. This interpretation applies not only to the following structural formula but also to other structural formulae.

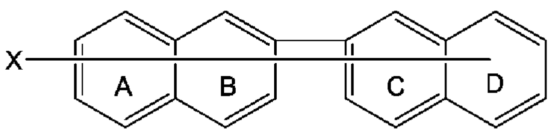

[Underlayer film forming composition]

The present embodiment relates to an underlayer film forming composition comprising:

a compound having a constituent unit represented by the following formula (1) (hereinafter, also referred to as a "compound represented by the formula (1)" or "compound of the present embodiment"), and
a solvent, wherein
the weight average molecular weight of the compound is 1,000 to 30,000 as the molecular weight in terms of polystyrene, and
the solubility of the compound in propylene glycol monomethyl ether acetate is 10% by mass or more at 23°C.

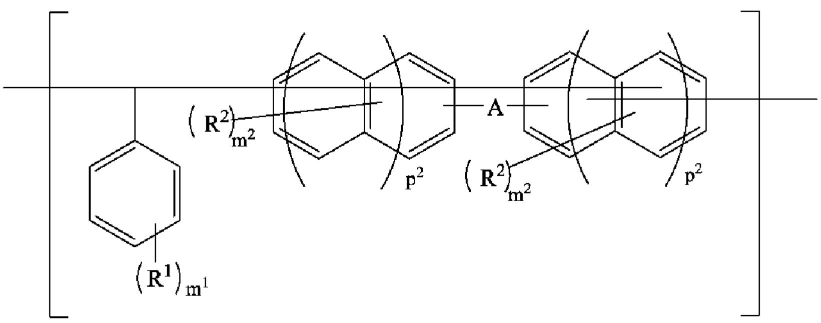

(1)

In the formula (1), A is a single bond or a divalent group; each $R^1$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group; each $R^2$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group, where at least one $R^2$ is a hydroxy group and/or thiol group; each $m^1$ is independently an integer of 0 to 5; each

$m^2$ is independently an integer of 0 to 8; and each $p^2$ is independently an integer of 0 to 2.

In the formula (1), A is a single bond or a divalent group and optionally contains a hetero atom. For example, included are a single bond, a sulfur atom, an oxygen atom, a linear, branched, or cyclic alkylene group having 1 to 10 carbon atoms, an arylene group having 6 to 10 carbon atoms, an alkenylene group having 2 to 10 carbon atoms, an alkynylene group having 2 to 10 carbon atoms, a carbonyl group, or a combination thereof.

In the formula (1), each $R^1$ is independently a monovalent group selected from the group consisting of a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, and a hydroxy group. Examples of the alkyl group include a linear or branched alkyl group such as a methyl group, an ethyl group, a n-propyl group, an isopropyl group, a n-butyl group, an isobutyl group, a sec-butyl group, a tert-butyl group, a pentyl group, and a hexyl group; and a cyclic alkyl group such as a cyclopentyl group, and a cyclohexyl group. Examples of the aryl group include a phenyl group, a naphthyl group, a tolyl group, and a xylyl group. Examples of the alkenyl group include an ethenyl group, a propenyl group, a butenyl group, a pentenyl group, and a hexenyl group. Examples of the alkynyl group include an ethynyl group, a 1-propynyl group, and a 2-propynyl group.

In the formula (1), each $R^2$ is independently a monovalent group selected from the group consisting of a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, and a hydroxy group. Examples of the alkyl group include a linear or branched alkyl group such as a methyl group, an ethyl group, a n-propyl group, an isopropyl group, a n-butyl group, an isobutyl group, a sec-butyl group, a tert-butyl group, a pentyl group, and a hexyl group; and a cyclic alkyl group such as a cyclopentyl group, and a cyclohexyl group. Examples of the aryl group include a phenyl group, a naphthyl group, a tolyl group, and a xylyl group. Examples of the alkenyl group include an ethenyl group, a propenyl group, a butenyl group, a pentenyl group, and a hexenyl group. Examples of the alkynyl group include an ethynyl group, a 1-propynyl group, and a 2-propynyl group. However, at least one $R^2$ is a hydroxy group and/or a thiol group.

In the formula (1), each $m^1$ is independently an integer of 0 to 5, preferably an integer of 0 to 4, and more preferably 1 or 2.

In the formula (1), each $m^2$ is independently an integer of 0 to 8, preferably an integer of 0 to 4, and more preferably 1 or 2.

In the formula (1), each $p^2$ is independently an integer of 0 to 2, preferably 0 or 1, and more preferably 0.

The compound represented by the above formula (1) has high heat resistance attributed to its rigid structure, in spite of its relatively low molecular weight, and can therefore be used even under high temperature baking conditions. Also, the compound represented by the above formula (1) has tertiary carbon or quaternary carbon in the molecule, which suppresses crystallization, and is thus suitably used as a film forming material for lithography.

The weight average molecular weight of the compound represented by the above formula (1) (Mw) is, as the molecular weight in terms of polystyrene, 1,000 to 30,000, preferably 1,000 to 25,000, more preferably 2,000 to 10,000, further preferably 2,500 to 5,000, and particularly preferably 3,000 to 5,000, from the viewpoint of heat resistance. The weight average molecular weight is determined by gel permeation chromatography (GPC) analysis under the measurement conditions described in Examples.

In addition, the compound represented by the above formula (1) has high solubility in an organic solvent (particularly, a safe solvent) and has excellent heat resistance and etching resistance. For this reason, an underlayer film forming composition containing the compound represented by the above formula (1) has excellent resist pattern formability.

Moreover, the compound represented by the above formula (1) has a relatively low molecular weight and a low viscosity, and therefore facilitates enhancing film smoothness while uniformly and completely filling even the steps of an uneven supporting material (particularly having fine space, hole pattern, etc.). As a result, an underlayer film forming composition containing the compound represented by the above formula (1) has excellent embedding properties and smoothing properties. In addition, the compound represented by the above formula (1) is a compound that has a relatively high carbon concentration, and can therefore exhibit high etching resistance, as well.

In the compound represented by the above formula (1), at least one $R^2$ is a hydroxy group and/or a thiol group from the viewpoint of easy crosslinking reaction and solubility in an organic solvent.

The compound represented by the above formula (1) is preferably a compound represented by the following formula (1a) from the viewpoint of easy crosslinking and solubility in an organic solvent.

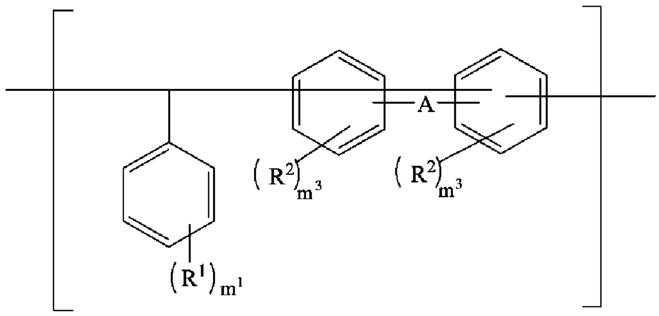

(1 a)

In the formula (1a), A, $R^1$, $R^2$, and $m^1$ are as defined above. Each $m^3$ is independently an integer of 0 to 4.

In addition, the compound represented by the above formula (1a) is preferably a compound represented by the following formula (1b) from the viewpoint of easy crosslinking and solubility in an organic solvent.

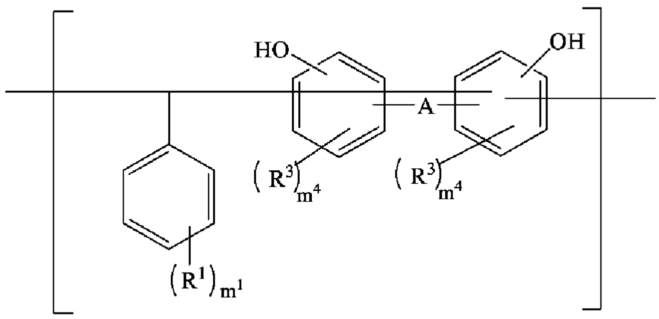

(1 b)

In the formula (1b), each $R^3$ is independently a linear, branched, or cyclic alkyl group having 1 to 10 carbon atoms, an aryl group having 6 to 10 carbon atoms, an alkenyl group having 2 to 10 carbon atoms, or an alkynyl group having 2 to 10 carbon atoms;

each $m^4$ is independently an integer of 0 to 3; and

A, $R^1$, and $m^1$ are as defined above.

The compound represented by the above formula (1b) is preferably a compound represented by the following formulae (1b-1) to (1b-5) from the viewpoint of the supply of raw materials.

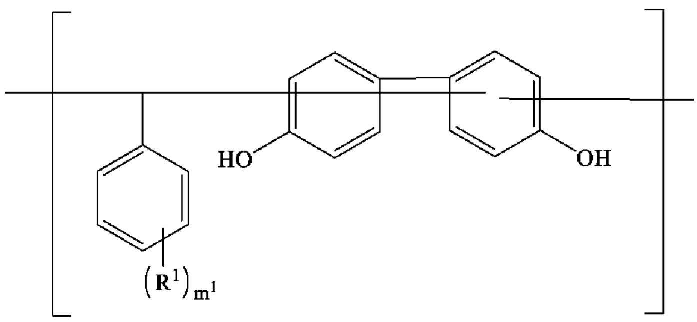

(1 b − 1)

In the formula (1b-1), $R^1$ and $m^1$ are as defined above.

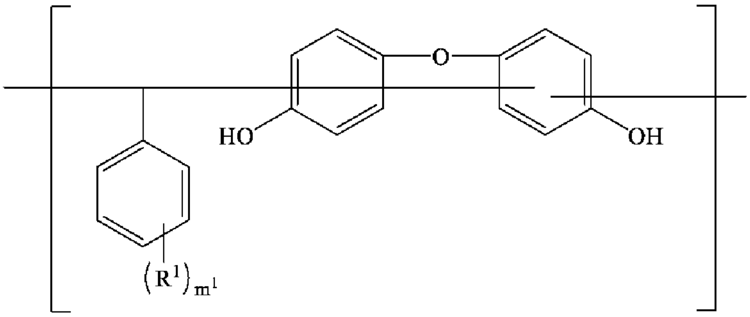

(1 b − 2)

In the formula (1b-2), $R^1$ and $m^1$ are as defined above.

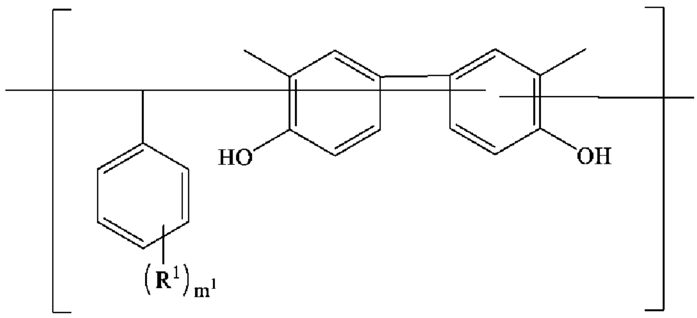

(1 b − 3)

In the formula (1b-3), $R^1$ and $m^1$ are as defined above.

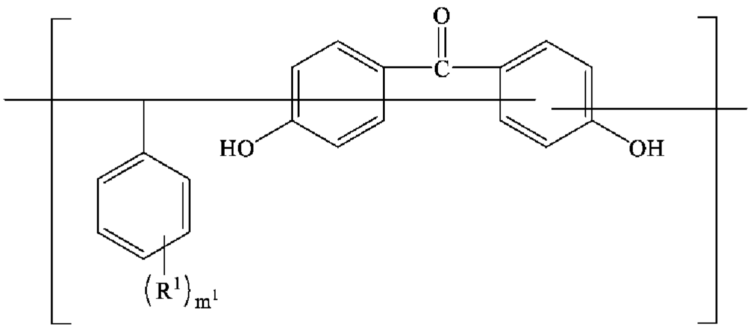

(1 b − 4)

In the formula (1b-4), $R^1$ and $m^1$ are as defined above.

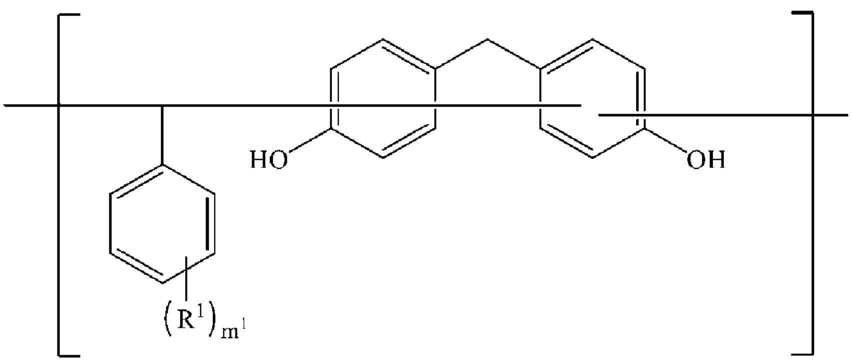

(1 b − 5)

In the formula (1b-5), $R^1$ and $m^1$ are as defined above.

Examples of the method for synthesizing the compound represented by the formula (1) include the following method. That is, the compound represented by the above formula (1) is obtained through a polycondensation reaction

between the compound represented by the following formula (1-x) and the compound represented by the following formula (z1) in the presence of an acid catalyst or base catalyst at normal pressure. If necessary, the above reaction may be carried out under increased pressure.

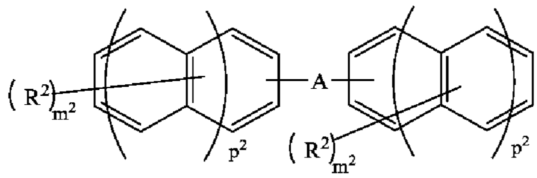

(1 − x)

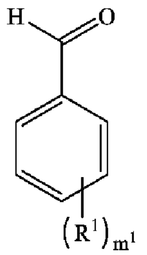

(z 1)

In the above formula (1-x), A, $R^2$, $m^2$, and $p^2$ are as defined in A, $R^2$, $m^2$, and $p^2$ in the formula (1), respectively.
In the above formula (z1), $R^1$ and $m^1$ are as defined in $R^1$ and $m^1$ in the above formula (1), respectively.
As a specific example of the above polycondensation reaction, the compound represented by the above formula (1) is obtained through a polycondensation reaction between a biphenol, a binaphthol, a dihydroxybenzophenone, a dihydroxyphenyl ether, a dihydroxydiphenylmethane, a dihydroxyphenyl thioether, a dihydroxynaphthyl ether, a dihydroxynaphthyl thioether, a dihydroxyanthracyl ether, or a dihydroxyanthracyl thioether and a corresponding aldehyde in the presence of an acid catalyst or base catalyst.
Among the above phenolic raw materials, a raw material in which aromatic rings are bonded to each other through a divalent group is more advantageous than a biphenol or a binaphthol, in which aromatic rings are bonded to each other through a single bond, from the viewpoint of heat fluidity and film smoothing properties, and a dihydroxybenzophenone, a dihydroxyphenyl ether, a dihydroxydiphenylmethane, a dihydroxyphenyl thioether, a dihydroxynaphthyl ether, a dihydroxynaphthyl thioether, a dihydroxyanthracyl ether, or a dihydroxyanthracyl thioether is preferable.
Examples of the biphenol include, without particular limitations, biphenol, dimethylbiphenol, and tetramethylbiphenol. These biphenols are used alone as one kind or in combination of two or more kinds. Among them, biphenol is preferably used from the viewpoint of the stable supply of raw materials.
Examples of the binaphthol include, without particular limitations, binaphthol, dimethylbinaphthol, and tetramethylbinaphthol. These binaphthols are used alone as one kind or in combination of two or more kinds. Among them, binaphthol is preferably used from the viewpoint of the stable supply of raw materials.
Examples of the dihydroxybenzophenone include, without particular limitations, dihydroxybenzophenone, dimethyl dihydroxybenzophenone, and tetramethyl dihydroxybenzophenone. These dihydroxybenzophenones are used alone as one kind or in combination of two or more kinds. Among them, dihydroxybenzophenone is preferably used from the viewpoint of the stable supply of raw materials.
Examples of the dihydroxyphenyl ether include, without particular limitations, dihydroxyphenyl ether, methyldihydroxyphenyl ether and methoxydihydroxyphenyl ether. These dihydroxyphenyl ethers are used alone as one kind or in combination of two or more kinds. Among them, it is preferable to use dihydroxyphenyl ether from the viewpoint of the stable supply of raw materials.
Examples of the dihydroxydiphenylmethane include, without particular limitations, dihydroxydiphenylmethane, dimethyl dihydroxydiphenylmethane, and tetramethyl dihydroxydiphenylmethane. These dihydroxydiphenylmethanes are used alone as one kind or in combination of two or more kinds. Among them, dihydroxydiphenylmethane is preferably used from the viewpoint of the stable supply of raw materials.
Examples of the dihydroxyphenyl thioether include, without particular limitations, dihydroxyphenyl thioether, methyldihydroxyphenyl thioether and methoxydihydroxyphenyl thioether. These dihydroxyphenyl thioethers are used alone as one kind or in combination of two or more kinds. Among them, it is preferable to use dihydroxyphenyl thioether from the viewpoint of the stable supply of raw materials.
Examples of the dihydroxynaphthyl ether include, without particular limitations, dihydroxynaphthyl ether, methyldihydroxynaphthyl ether and methoxydihydroxynaphthyl ether. These dihydroxynaphthyl ethers are used alone as one kind or in combination of two or more kinds. Among them, it is preferable to use dihydroxynaphthyl ether from the viewpoint of increasing a carbon atom concentration and improving heat resistance.

Examples of the dihydroxynaphthyl thioether include, without particular limitations, dihydroxynaphthyl thioether, methyldihydroxynaphthyl thioether and methoxydihydroxynaphthyl thioether. These dihydroxynaphthyl thioethers are used alone as one kind or in combination of two or more kinds. Among them, it is preferable to use dihydroxynaphthyl thioether from the viewpoint of increasing a carbon atom concentration and improving heat resistance.

Examples of the dihydroxyanthracyl ether include, without particular limitations, dihydroxyanthracyl ether, methyl dihydroxyanthracyl ether, and methoxy dihydroxyanthracyl ether. These dihydroxyanthracyl ethers are used alone as one kind or in combination of two or more kinds. Among them, dihydroxyanthracyl ether is preferably used from the viewpoint of increasing a carbon atom concentration and improving heat resistance.

Examples of the dihydroxyanthracyl thioether include, without particular limitations, dihydroxyanthracyl thioether, methyl dihydroxyanthracyl thioether, and methoxy dihydroxyanthracyl thioether. These dihydroxyanthracyl thioethers are used alone as one kind or in combination of two or more kinds. Among them, dihydroxyanthracyl thioether is preferably used from the viewpoint of increasing a carbon atom concentration and improving heat resistance.

The aldehyde is not particularly limited as long as being benzaldehyde or a derivative thereof, and examples thereof include benzaldehyde, phenylacetaldehyde, phenylpropylaldehyde, hydroxybenzaldehyde, chlorobenzaldehyde, nitrobenzaldehyde, methylbenzaldehyde, dimethylbenzaldehyde, trimethylbenzaldehyde, ethylbenzaldehyde, propylbenzaldehyde, butylbenzaldehyde, pentabenzaldehyde, butylmethylbenzaldehyde, dihydroxybenzaldehyde, trihydroxybenzaldehyde, fluoromethylbenzaldehyde, cyclopropylbenzaldehyde, cyclobutylbenzaldehyde, cyclohexylbenzaldehyde, cyclodecylbenzaldehyde, cycloundecylbenzaldehyde, or biphenylaldehyde. These aldehydes are used alone as one kind or in combination of two or more kinds. Among them, it is preferable to use one or more selected from the group consisting of benzaldehyde, phenylacetaldehyde, phenylpropylaldehyde, hydroxybenzaldehyde, nitrobenzaldehyde, methylbenzaldehyde, ethylbenzaldehyde, propylbenzaldehyde, butylbenzaldehyde, cyclohexylbenzaldehyde, or biphenylaldehyde from the viewpoint that high heat resistance can be exhibited, and it is more preferable to use biphenylaldehyde from the viewpoint of improving etching resistance.

Examples of the acid catalyst to be used in the above reaction include, without particular limitations, an inorganic acid such as hydrochloric acid, sulfuric acid, phosphoric acid, hydrobromic acid, and hydrofluoric acid; an organic acid such as oxalic acid, malonic acid, succinic acid, adipic acid, sebacic acid, citric acid, fumaric acid, maleic acid, formic acid, p-toluenesulfonic acid, methanesulfonic acid, trifluoroacetic acid, dichloroacetic acid, trichloroacetic acid, trifluoromethanesulfonic acid, benzenesulfonic acid, naphthalenesulfonic acid, and naphthalenedisulfonic acid; a Lewis acid such as zinc chloride, aluminum chloride, iron chloride, and boron trifluoride; and a solid acid such as tungstosilicic acid, tungstophosphoric acid, silicomolybdic acid, and phosphomolybdic acid. These acid catalysts are used alone as one kind or in combination of two or more kinds. Among them, organic acids and solid acids are preferable from the viewpoint of production, and it is preferable to use hydrochloric acid or sulfuric acid from the viewpoint of production such as easy availability and handleability. The amount of the acid catalyst used can be arbitrarily set according to, for example, the kind of the raw materials used and the catalyst used and moreover the reaction conditions and is not particularly limited, but is preferably 0.01 to 100 parts by mass based on 100 parts by mass of the reaction raw materials.

Examples of the base catalyst to be used in the above reaction include, without particular limitations, a metal alkoxide (for example, an alkali metal or alkaline earth metal alkoxide such as sodium methoxide, sodium ethoxide, potassium methoxide and potassium ethoxide), a metal hydroxide (for example, an alkali metal or alkaline earth metal hydroxide such as sodium hydroxide and potassium hydroxide), an alkali metal or alkaline earth bicarbonate such as sodium bicarbonate and potassium bicarbonate, and an organic base of an amine (for example, a tertiary amine (a trialkylamine such as triethylamine, an aromatic tertiary amine such as N,N-dimethylaniline, and a heterocyclic tertiary amine such as 1-methylimidazole)), and a metal carboxylate (for example, an alkali metal or alkaline earth metal acetate such as sodium acetate and calcium acetate). These base catalysts are used alone as one kind or in combination of two or more kinds. Among them, metal alkoxides, metal hydroxides and amines are preferable from the viewpoint of production, and it is preferable to use sodium hydroxide from the viewpoint of production such as easy availability and handleability. The amount of the base catalyst used can be arbitrarily set according to, for example, the kind of the raw materials used and the catalyst used and moreover the reaction conditions and is not particularly limited, but is preferably 0.01 to 100 parts by mass based on 100 parts by mass of the reaction raw materials.

Upon the above reaction, a reaction solvent may be used. Examples of the reaction solvent include, without particular limitations, water, methanol, ethanol, propanol, butanol, tetrahydrofuran, dioxane, ethylene glycol dimethyl ether, and ethylene glycol diethyl ether. These solvents are used alone as one kind or in combination of two or more kinds.

The amount of the solvent used can be arbitrarily set according to, for example, the kind of the raw materials used and the catalyst used and moreover the reaction conditions and is not particularly limited, but is preferably in the range of 0 to 2000 parts by mass based on 100 parts by mass of the reaction raw materials. Furthermore, the reaction temperature in the above reaction can be arbitrarily selected according to the reactivity of the reaction raw materials

and is not particularly limited, but is usually within the range of 10 to 200°C.

In order to obtain the compound represented by the formula (1) of the present embodiment, a higher reaction temperature is preferable. Specifically, the range of 60 to 200°C is preferable. Although the reaction method is not particularly limited, for example, the raw materials (reactants) and the catalyst may be fed in a batch, or the raw materials (reactants) may be dripped successively in the presence of the catalyst. After the polycondensation reaction terminates, isolation of the obtained compound can be carried out according to a conventional method, and is not particularly limited. For example, by adopting a commonly used approach in which the temperature of the reaction vessel is elevated to 130 to 230°C in order to remove unreacted raw materials, catalyst, etc. present in the system, and volatile portions are removed at about 1 to 50 mmHg, the compound that is the target compound can be obtained.

Examples of the preferable reaction conditions include conditions under which the reaction proceeds by using 1.0 mol to an excess of the compound represented by the above formula (1-x) based on 1 mol of the aldehyde represented by the above formula (z1), further using 0.001 to 1 mol of the acid catalyst, and reacting them at 50 to 150°C at normal pressure for about 20 minutes to 100 hours.

The compound can be isolated by a publicly known method after the reaction terminates. The compound represented by the above formula (1) which is the target compound can be obtained by, for example, concentrating the reaction liquid, precipitating the reaction product by the addition of pure water, cooling the reaction liquid to room temperature, then separating the precipitates by filtration, drying the obtained solid matter, then separating and purifying the solid matter from by-products by column chromatography, and distilling off the solvent, followed by filtration and drying.

Here, the resin of the present embodiment may be a homopolymer of the compound represented by the above formula (1) as long as the effect of the invention is not impaired, or may be a copolymer with a further phenol. Here, examples of the copolymerizable phenol include, without particular limitations, phenol, cresol, dimethylphenol, trimethylphenol, butylphenol, phenylphenol, diphenylphenol, naphthylphenol, resorcinol, methylresorcinol, catechol, butylcatechol, methoxyphenol, methoxyphenol, propylphenol, pyrogallol, and thymol.

In addition, the compound of the present embodiment may be a copolymer with a polymerizable monomer other than the further phenol mentioned above as long as the effect of the invention is not impaired. Examples of the copolymerization monomer include, without particular limitations, naphthol, methylnaphthol, methoxynaphthol, dihydroxynaphthalene, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, vinylnorbornene, pinene, and limonene. The resin of the present embodiment may be a copolymer of two or more components (for example, a binary to quaternary system) composed of the compound represented by the above formula (1) and the above phenol, may be a copolymer of two or more components (for example, a binary to quaternary system) composed of the compound represented by the above formula (1) and the above copolymerization monomer, or may be a copolymer of three or more components (for example, a tertiary to quaternary system) composed of the compound represented by the above formula (1), the above phenol, and the above copolymerization monomer.

The compound represented by the above formula (1) preferably has high solubility in a solvent from the viewpoint of easier application to a wet process, etc. More specifically, the solubility of the compound represented by the formula (1) in propylene glycol monomethyl ether acetate (PGMEA) is 10% by mass or more, preferably 20% by mass or more, and more preferably 30% by mass or more at 23°C. Here, the solubility S is represented by the following formula, wherein A is the mass of PGMEA, and B is the maximum mass of the compound represented by the formula (1) dissolved in the mass of PGMEA.

$$S = [B/(B + A)] \times 100$$

For example, 10 g of the compound represented by the above formula (1) is evaluated as being dissolved in 90 g of PGMEA when the solubility of the compound represented by the formula (1) in PGMEA is "10% by mass or more"; 10 g of the compound is evaluated as being not dissolved in 90 g of PGMEA when the solubility is "less than 10% by mass".

The composition of the present embodiment contains the compound of the present embodiment and thus is applicable to a wet process and is excellent in heat resistance and smoothing properties. Furthermore, the composition of the present embodiment contains the compound of the present embodiment and thus can form a film for lithography that is prevented from deteriorating during high temperature baking and is excellent in etching resistance against oxygen plasma etching or the like. Furthermore, the composition of the present embodiment is also excellent in adhesiveness to a resist layer and can therefore form an excellent resist pattern. For this reason, the composition of the present embodiment can be suitably used for forming an underlayer film.

The underlayer film forming composition of the present embodiment further contains a solvent. The underlayer film forming composition of the present embodiment may contain a crosslinking agent, a crosslinking promoting agent, an acid generating agent, a basic compound, and additional components, if required. These components will be described

below.

[Solvent]

The underlayer film forming composition of the present embodiment contains a solvent. The solvent is not particularly limited as long as it is a solvent that can dissolve the compound of the present embodiment. Here, the compound of the present embodiment has excellent solubility in an organic solvent, as mentioned above, and therefore, various organic solvents are suitably used.

Examples of the solvent include, without particular limitations: a ketone-based solvent such as acetone, methyl ethyl ketone, methyl isobutyl ketone, and cyclohexanone; a cellosolve-based solvent such as propylene glycol monomethyl ether and propylene glycol monomethyl ether acetate; an ester-based solvent such as ethyl lactate, methyl acetate, ethyl acetate, butyl acetate, isoamyl acetate, ethyl lactate, methyl methoxypropionate, and methyl hydroxyisobutyrate; an alcohol-based solvent such as methanol, ethanol, isopropanol, and 1-ethoxy-2-propanol; and an aromatic hydrocarbon such as toluene, xylene, and anisole. These solvents are used alone as one kind or in combination of two or more kinds.

Among the above solvents, from the viewpoint of safety, one or more selected from the group consisting of cyclohexanone, propylene glycol monomethyl ether, propylene glycol monomethyl ether acetate, ethyl lactate, methyl hydroxyisobutyrate and anisole are preferable.

The content of the solvent is not particularly limited and is preferably 50 to 99 parts by mass based on 100 parts by mass of the underlayer film forming composition, more preferably 66 to 98 parts by mass, and still more preferably 75 to 97 parts by mass, from the viewpoint of solubility and film formation.

[Crosslinking agent]

The underlayer film forming composition of the present embodiment may contain a crosslinking agent from the viewpoint of, for example, suppressing intermixing. The crosslinking agent is not particularly limited, but a crosslinking agent described in, for example, International Publication No. WO 2013/024779 or WO 2018/016614 can be used.

Examples of the crosslinking agent include, without particular limitations, a phenol compound, an epoxy compound, a cyanate compound, an amino compound, a benzoxazine compound, an acrylate compound, a melamine compound, a guanamine compound, a glycoluril compound, a urea compound, an isocyanate compound, and an azide compound. These crosslinking agents are used alone as one kind or in combination of two or more kinds. Among them, one or more selected from the group consisting of a benzoxazine compound, an epoxy compound and a cyanate compound are preferable, and a benzoxazine compound is more preferable from the viewpoint of improvement in etching resistance.

As the phenol compound, a publicly known one can be used, and such phenol compounds are used alone as one kind or in combination of two or more kinds. Among them, an aralkyl-based phenol resin is preferable from the viewpoint of heat resistance and solubility.

As the epoxy compound, a publicly known one can be used, and such epoxy compounds are used alone as one kind or in combination of two or more kinds. Among them, an epoxy resin that is in a solid state at normal temperature, such as an epoxy resin obtained from a phenol aralkyl resin or a biphenyl aralkyl resin is preferable from the viewpoint of heat resistance and solubility.

The cyanate compound is not particularly limited as long as the compound has two or more cyanate groups in one molecule, and a publicly known one can be used. Such cyanate compounds are used alone as one kind or in combination of two or more kinds. The cyanate compound may be in any form of a monomer, an oligomer, and a resin. Also, the cyanate compound preferably has an aromatic group, and those having a structure in which a cyanate group is directly bonded to the aromatic group can be suitably used. Examples of such a cyanate compound include those having a structure in which hydroxy groups of bisphenol A, bisphenol F, bisphenol M, bisphenol P, bisphenol E, a phenol novolac resin, a cresol novolac resin, a dicyclopentadiene novolac resin, tetramethylbisphenol F, a bisphenol A novolac resin, a brominated bisphenol A, a brominated phenol novolac resin, a trifunctional phenol, a tetrafunctional phenol, a naphthalene-based phenol, a biphenyl-based phenol, a phenol aralkyl resin, a biphenyl aralkyl resin, a naphthol aralkyl resin, a dicyclopentadiene aralkyl resin, an alicyclic phenol, a phosphorus-containing phenol, or the like are replaced with cyanate groups.

The amino compound is not particularly limited, and a publicly known one can be used. Such amino compounds are used alone as one kind or in combination of two or more kinds. Among them, preferable are one or more selected from the group consisting of an aromatic amine such as 4,4'-diaminodiphenylmethane, 4,4'-diaminodiphenylpropane, 4,4'-diaminodiphenyl ether, 3,4'-diaminodiphenyl ether, 3,3'-diaminodiphenyl ether, 4,4'-diaminodiphenylsulfone, 3,3'-diaminodiphenylsulfone, 1,4-bis(4-aminophenoxy)benzene, 1,3-bis(4-aminophenoxy)benzene, 1,4-bis(3-aminophenoxy)benzene, 1,3-bis(3-aminophenoxy)benzene, bis[4-(4-aminophenoxy)phenyl]sulfone, 2,2-bis[4-(4-aminophenoxy)phenyl]propane, 2,2-bis[4-(3-aminophenoxy)phenyl]propane, 4,4'-bis(4-aminophenoxy)biphenyl, 4,4'-bis(3-aminophenoxy)biphenyl, bis[4-(4-aminophenoxy)phenyl] ether, and bis[4-(3-aminophenoxy)phenyl] ether; an alicyclic amine such as diaminocyclohexane, diaminodicyclohexylmethane, dimethyl-diaminodicyclohexylmethane, tetramethyl-diaminodicyclohexylmethane, diaminodicyclohexylpropane, diaminobicyclo[2.2.1]heptane, bis(aminomethyl)-bicyclo[2.2.1]heptane, 3(4),8(9)-bis(aminomethyl)tricyclo[5.2.1.02,6]decane, 1,3-bisaminomethylcyclohexane, and isophoronediamine; and an aliphatic amine such as ethylenediamine, hexamethylenediamine, octamethylenediamine, decamethylenediamine, diethylenetriamine, and triethylenetetramine.

The benzoxazine compound is not particularly limited, and a publicly known one can be used. Such benzoxazine compounds are used alone as one kind or in combination of two or more kinds.

The melamine compound is not particularly limited, and a publicly known one can be used. Such melamine compounds are used alone as one kind or in combination of two or more kinds.

The guanamine compound is not particularly limited, and a publicly known one can be used. Such guanamine compounds are used alone as one kind or in combination of two or more kinds.

The glycoluril compound is not particularly limited, and a publicly known one can be used. Such glycoluril compounds are used alone as one kind or in combination of two or more kinds.

The urea compound is not particularly limited, and a publicly known one can be used. Such urea compounds are used alone as one kind or in combination of two or more kinds.

In the underlayer film forming composition of the present embodiment, a crosslinking agent having at least one allyl group may be used from the viewpoint of improvement in crosslinkability. The crosslinking agent having at least one allyl group is not particularly limited, and a publicly known one can be used. Such crosslinking agents are used alone as one kind or in combination of two or more kinds. Among them, an allylphenol such as 2,2-bis(3-allyl-4-hydroxyphenyl)propane, 1,1,1,3,3,3-hexafluoro-2,2-bis(3-allyl-4-hydroxyphenyl)propane, bis(3-allyl-4-hydroxyphenyl)sulfone, bis(3-allyl-4-hydroxyphenyl)sulfide, or bis(3-allyl-4-hydroxyphenyl) ether is preferable.

In the present embodiment, the content of the crosslinking agent is not particularly limited and is preferably 0.1 to 100 parts by mass based on 100 parts by mass of the compound of the present embodiment, more preferably 5 to 50 parts by mass, and still more preferably 10 to 40 parts by mass. By setting the content of the crosslinking agent to the above range, occurrence of a mixing event with a resist layer tends to be prevented. Also, an antireflection effect is enhanced, and film formability after crosslinking tends to be enhanced.

[Crosslinking promoting agent]

The underlayer film forming composition of the present embodiment may contain a crosslinking promoting agent for accelerating crosslinking reaction (curing reaction), if required. Examples of the crosslinking promoting agent include a radical polymerization initiator.

The radical polymerization initiator may be a photopolymerization initiator that initiates radical polymerization by light, or may be a thermal polymerization initiator that initiates radical polymerization by heat. Examples of the radical polymerization initiator include at least one selected from the group consisting of a ketone-based photopolymerization initiator, an organic peroxide-based polymerization initiator and an azo-based polymerization initiator.

Such a radical polymerization initiator is not particularly limited, and examples thereof include those described in International Publication No. WO 2018/016614. Such radical polymerization initiators are used alone as one kind or in combination of two or more kinds.

[Acid generating agent]

The underlayer film forming composition of the present embodiment may contain an acid generating agent from the viewpoint of, for example, further accelerating crosslinking reaction by heat. An acid generating agent that generates an acid by thermal decomposition, an acid generating agent that generates an acid by light irradiation, and the like are known, any of which can be used. For example, an acid generating agent described in International Publication No. WO 2013/024779 can be used.

The content of the acid generating agent in the underlayer film forming composition is not particularly limited and is preferably 0.1 to 50 parts by mass, and more preferably 0.5 to 40 parts by mass, based on 100 parts by mass of the compound of the present embodiment. By setting the content of the acid generating agent to the above range, crosslinking reaction tends to be enhanced and occurrence of a mixing event with a resist layer tends to be prevented.

[Basic compound]

The underlayer film forming composition of the present embodiment may contain a basic compound from the viewpoint of, for example, improving storage stability.

The basic compound plays a role to prevent crosslinking reaction from proceeding due to a trace amount of an acid generated from the acid generating agent, that is, a role as a quencher against the acid. The storage stability of the underlayer film forming composition is improved. Examples of such a basic compound include, without particular limitations, those described in International Publication No. WO 2013/024779.

The content of the basic compound in the compound of the present embodiment is not particularly limited and is preferably 0.001 to 2 parts by mass, and more preferably 0.01 to 1 part by mass, based on 100 parts by mass of the compound of the present embodiment. By setting the content of the basic compound to the above range, storage stability tends to be enhanced without excessively deteriorating crosslinking reaction.

[Further additive agent]

The underlayer film forming composition of the present embodiment may also contain an additional resin and/or compound for the purpose of conferring thermosetting or light curing properties or controlling absorbance. Examples of such an additional resin and/or compound include, without particular limitations, a naphthol resin, a xylene resin naphthol-modified resin, a phenol-modified resin of a naphthalene resin; a polyhydroxystyrene, a dicyclopentadiene resin, a resin containing (meth)acrylate, dimethacrylate, trimethacrylate, tetramethacrylate, a naphthalene ring such as vinylnaphthalene or polyacenaphthylene, a biphenyl ring such as phenanthrenequinone or fluorene, or a heterocyclic ring having a heteroatom such as thiophene or indene, and a resin containing no aromatic ring; and a resin or compound containing an alicyclic structure, such as a rosin-based resin, a cyclodextrin, an adamantine(poly)ol, a tricyclodecane(poly)ol, and a derivative thereof. The underlayer film forming composition of the present embodiment may also contain a publicly known additive agent. Examples of the publicly known additive agent include, but not limited to, a thermal and/or light curing catalyst, a polymerization inhibitor, a flame retardant, a filler, a coupling agent, a thermosetting resin, a light curable resin, a dye, a pigment, a thickener, a lubricant, an antifoaming agent, a leveling agent, an ultraviolet absorber, a surfactant, a colorant, and a nonionic surfactant.

[Underlayer film for lithography]

The underlayer film for lithography according to the present embodiment is formed from the underlayer film forming composition of the present embodiment.

[Resist pattern formation method]

The resist pattern formation method of the present embodiment comprises: an underlayer film formation step of forming an underlayer film on a supporting material using the underlayer film forming composition of the present embodiment; a photoresist layer formation step of forming at least one photoresist layer on the underlayer film formed through the underlayer film formation step; and a step of irradiating a predetermined region of the photoresist layer formed through the photoresist layer formation step with radiation for development. The resist pattern formation method of the present embodiment can be used for forming various patterns, and is preferably a method for forming an insulating film pattern.

[Circuit pattern formation method]

The circuit pattern formation method of the present embodiment comprises: an underlayer film formation step of forming an underlayer film on a supporting material using the underlayer film forming composition of the present embodiment; an intermediate layer film formation step of forming an intermediate layer film on the underlayer film formed through the underlayer film formation step; a photoresist layer formation step of forming at least one photoresist layer on the intermediate layer film formed through the intermediate layer film formation step; a resist pattern formation step of irradiating a predetermined region of the photoresist layer formed through the photoresist layer formation step with radiation for development, thereby forming a resist pattern; an intermediate layer film pattern formation step of etching the intermediate layer film with the resist pattern formed through the resist pattern formation step as a mask, thereby forming an intermediate layer film pattern; an underlayer film pattern formation step of etching the underlayer film with the intermediate layer film pattern formed through the intermediate layer film pattern formation step as a mask, thereby forming an underlayer film pattern; and a supporting material pattern formation step of etching the supporting material with the underlayer film pattern formed through the underlayer film pattern formation step as a mask, thereby forming a pattern on the supporting material.

The underlayer film for lithography of the present embodiment is formed from the underlayer film forming composition of the present embodiment. The formation method is not particularly limited and a publicly known method can be applied. The underlayer film can be formed by, for example, applying the underlayer film forming composition of

the present embodiment onto a supporting material by a publicly known coating method or printing method such as spin coating or screen printing, and then removing an organic solvent by volatilization or the like.

It is preferable to perform baking in the formation of the underlayer film, for preventing occurrence of a mixing event with a resist upper layer film while accelerating crosslinking reaction. In this case, the baking temperature is not particularly limited and is preferably in the range of 80 to 450°C, and more preferably 200 to 400°C. The baking time is not particularly limited and is preferably in the range of 10 to 300 seconds. The thickness of the underlayer film can be arbitrarily selected according to required performance and is not particularly limited, but is preferably 30 to 20,000 nm, and more preferably 50 to 15,000 nm.

Additionally, baking is preferably performed in an inert gas environment, and performing baking in a nitrogen atmosphere or argon atmosphere, for example, is preferable because the heat resistance of the underlayer film for lithography can be improved and the etching resistance thereof also can be improved.

After preparing the underlayer film, it is preferable to prepare a silicon-containing resist layer or a single-layer resist made of hydrocarbon on the underlayer film in the case of a two-layer process, and to prepare a silicon-containing intermediate layer on the underlayer film and further prepare a silicon-free single-layer resist layer on the silicon-containing intermediate layer in the case of a three-layer process. In this case, a publicly known photoresist material can be used for forming this resist layer.

For the silicon-containing resist material for a two-layer process, a silicon atom-containing polymer such as a polysilsesquioxane derivative or a vinylsilane derivative is used as a base polymer, and a positive type photoresist material further containing an organic solvent, an acid generating agent, and if required, a basic compound or the like is preferably used, from the viewpoint of oxygen gas etching resistance. Here, a publicly known polymer that is used in this kind of resist material can be used as the silicon atom-containing polymer.

A polysilsesquioxane-based intermediate layer is preferably used as the silicon-containing intermediate layer for a three-layer process. By imparting effects as an antireflection film to the intermediate layer, there is a tendency that reflection can be effectively suppressed. For example, use of a material containing a large amount of an aromatic group and having high supporting material etching resistance as the underlayer film in a process for exposure at 193 nm tends to increase a k value and enhance supporting material reflection. However, the intermediate layer suppresses the reflection so that the supporting material reflection can be 0.5% or less. The intermediate layer having such an antireflection effect is not limited, and polysilsesquioxane that crosslinks by an acid or heat in which a light absorbing group having a phenyl group or a silicon-silicon bond is introduced is preferably used for exposure at 193 nm.

Alternatively, an intermediate layer formed by chemical vapour deposition (CVD) may be used. The intermediate layer highly effective as an antireflection film prepared by CVD is not limited, and, for example, a SiON film is known. In general, the formation of an intermediate layer by a wet process such as spin coating or screen printing is more convenient and more advantageous in cost than CVD. The upper layer resist for a three-layer process may be positive type or negative type, and the same as a single-layer resist generally used can be used.

The underlayer film according to the present embodiment can also be used as an antireflection film for usual single-layer resists or an underlying material for suppression of pattern collapse. The underlayer film is excellent in etching resistance for an underlying process and can be expected to also function as a hard mask for an underlying process.

In the case of forming a resist layer from the above photoresist material, a wet process such as spin coating or screen printing is preferably used, as in the case of forming the above underlayer film. After coating with the resist material by spin coating or the like, prebaking is generally performed. This prebaking is preferably performed at 80 to 180°C in the range of 10 to 300 seconds. Then, exposure, post-exposure baking (PEB), and development can be performed according to a conventional method to obtain a resist pattern. The thickness of the resist film is not particularly limited, and in general, is preferably 30 to 500 nm and more preferably 50 to 400 nm.

The exposure light can be arbitrarily selected and used according to the photoresist material to be used. General examples thereof can include a high energy ray having a wavelength of 300 nm or less, specifically, excimer laser of 248 nm, 193 nm, or 157 nm, soft x-ray of 3 to 20 nm, electron beam, and X-ray.

In a resist pattern formed by the above method, pattern collapse is suppressed by the underlayer film. Therefore, use of the underlayer film according to the present embodiment can produce a finer pattern and can reduce an exposure amount necessary for obtaining the resist pattern.

Next, etching is performed with the obtained resist pattern as a mask. Gas etching is preferably used as the etching of the underlayer film in a two-layer process. The gas etching is suitably etching using oxygen gas. In addition to oxygen gas, an inert gas such as He or Ar, or CO, $CO_2$, $NH_3$, $SO_2$, $N_2$, $NO_2$, or $H_2$ gas may be added. Alternatively, the gas etching may be performed with CO, $CO_2$, $NH_3$, $N_2$, $NO_2$, or $H_2$ gas without the use of oxygen gas. Particularly, the latter gas is preferably used for side wall protection in order to prevent the undercut of pattern side walls.

On the other hand, gas etching is also preferably used as the etching of the intermediate layer in a three-layer process. The same gas etching as described in the above two-layer process is applicable. Particularly, it is preferable to process the intermediate layer in a three-layer process by using chlorofluorocarbon-based gas and using the resist

pattern as a mask. Then, as mentioned above, for example, the underlayer film can be processed by oxygen gas etching with the intermediate layer pattern as a mask.

Herein, in the case of forming an inorganic hard mask intermediate layer film as the intermediate layer, a silicon oxide film, a silicon nitride film, or a silicon oxynitride film (SiON film) is formed by CVD, ALD, or the like. A method for forming the nitride film is not limited, and, for example, a method described in Japanese Patent Laid-Open No. 2002-334869 or WO 2004/066377 can be used. Although a photoresist film can be formed directly on such an intermediate layer film, an organic antireflection film (BARC) may be formed on the intermediate layer film by spin coating and a photoresist film may be formed thereon.

A polysilsesquioxane-based intermediate layer is suitably used as the intermediate layer. By imparting effects as an antireflection film to the resist intermediate layer film, there is a tendency that reflection can be effectively suppressed. A specific material for the polysilsesquioxane-based intermediate layer is not limited, and, for example, a material described in Japanese Patent Laid-Open No. 2007-226170 or Japanese Patent Laid-Open No. 2007-226204 can be used.

The subsequent etching of the supporting material can also be performed by a conventional method. For example, the supporting material made of $SiO_2$ or SiN can be etched mainly using chlorofluorocarbon-based gas, and the supporting material made of p-Si, Al, or W can be etched mainly using chlorine- or bromine-based gas. In the case of etching the supporting material with chlorofluorocarbon-based gas, the silicon-containing resist of the two-layer resist process or the silicon-containing intermediate layer of the three-layer process is stripped at the same time with supporting material processing. On the other hand, in the case of etching the supporting material with chlorine- or bromine-based gas, the silicon-containing resist layer or the silicon-containing intermediate layer is separately stripped and in general, stripped by dry etching using chlorofluorocarbon-based gas after supporting material processing.

A feature of the underlayer film of the present embodiment is that it is excellent in etching resistance of the supporting materials. The supporting material can be arbitrarily selected for use from publicly known ones and is not particularly limited. Examples thereof include Si, $\alpha$-Si, p-Si, $SiO_2$, SiN, SiON, W, TiN, and Al. The supporting material may be a laminate having a film to be processed (supporting material to be processed) on a base material (support). Examples of such a film to be processed include various low-k films such as Si, $SiO_2$, SiON, SiN, p-Si, $\alpha$-Si, W, W-Si, Al, Cu, and Al-Si, and stopper films thereof. A material different from that for the base material (support) is generally used. The thickness of the supporting material to be processed or the film to be processed is not particularly limited and is generally preferably about 50 to 1,000,000 nm, and more preferably 75 to 50,000 nm.

[Resist permanent film]

The resist permanent film of the present embodiment is formed from the composition of the present embodiment. The resist permanent film prepared by coating with the composition of the present embodiment is suitable as a permanent film that also remains in a final product, if required, after formation of a resist pattern. Specific examples of the permanent film include, in relation to semiconductor devices, a solder resist, a package material, an underfill material, a package adhesive layer for circuit elements and the like, and an adhesive layer between integrated circuit elements and circuit substrates, and in relation to thin displays, a thin film transistor protecting film, a liquid crystal color filter protecting film, a black matrix, and a spacer. Particularly, the resist permanent film containing the composition of the present embodiment is excellent in heat resistance and humidity resistance and furthermore, also has the excellent advantage that contamination by sublimable components is reduced. Particularly, for a display material, a material that achieves all of high sensitivity, high heat resistance, and hygroscopic reliability with reduced deterioration in image quality due to significant contamination can be obtained.

In the case of using the underlayer film forming composition of the present embodiment for resist permanent film purposes, a curing agent as well as, if required, various additive agents such as an additional resin, a surfactant, a dye, a filler, a crosslinking agent, and a dissolution promoting agent can be added and dissolved in an organic solvent to prepare a composition for resist permanent films.

The underlayer film forming composition of the present embodiment can be prepared by adding each of the above components and mixing them using a stirrer or the like. When the composition of the present embodiment contains a filler or a pigment, it can be prepared by dispersion or mixing using a dispersion apparatus such as a dissolver, a homogenizer, and a three-roll mill.

Examples

The present embodiment will be described in more detail with reference to synthesis working examples and examples below. However, the present embodiment is not limited to these examples by any means.

(Carbon concentration and oxygen concentration)

The carbon concentration and the oxygen concentration (% by mass) of the compound or the resin were measured by organic elemental analysis by using a product manufactured by Yaic. Yanaco, "CHN Coder MT-6".

(Molecular weight)

The molecular weight of the compound or the resin was measured through LC-MS analysis by using a product manufactured by Waters Corp., "Acquity UPLC/MALDI-Synapt HDMS".

(Synthesis Working Example 1) Synthesis of PBiP-1

A container (internal capacity: 200 mL) equipped with a stirrer, a condenser tube, and a burette was prepared. To this container, 30 g (161 mmol) of 4,4-biphenol (a reagent manufactured by Tokyo Chemical Industry Co., Ltd.), 15 g (82 mmol) of 4-biphenylaldehyde (manufactured by Mitsubishi Gas Chemical Company, Inc.), and 100 mL of 1-butanol were added, and 2.1 g (21 mmol) of sulfuric acid (a reagent manufactured by Kanto Chemical Co., Inc.) was added to prepare a reaction liquid. This reaction liquid was stirred under reflex for 6 hours and reacted while by-produced water was removed. Next, the reaction liquid was neutralized with sodium carbonate and sodium hydrogen carbonate and then concentrated, and 50 g of toluene was added to precipitate a reaction product. After cooling to room temperature, the crude product was separated by filtration.

The crude product was dissolved in ethyl acetate, followed by washing with a sodium carbonate aqueous solution, a hydrochloric acid aqueous solution, and subsequently water. Then the resultant was dehydrated over sodium sulfate and concentrated, and toluene was added to the concentrated liquid to precipitate the target compound. The solid matter obtained by filtration was dried to obtain 3.0 g of the objective compound (PBiP-1) represented by the following formula.

The following peaks were found by 400 MHz-1H-NMR, and the compound was confirmed to have a chemical structure of the following formula (PBiP-1).
1H-NMR: (d-DMSO, internal standard TMS)
$\delta$ (ppm) 9.4 (O-H), 6.8-7.8 (Ph-H), 6.2 (C-H)
As a result of GPC analysis of the obtained compound, the weight average molecular weight measured was 5146.

The obtained compound had a decreasing rate of weight of less than 10% under nitrogen at 400°C and was confirmed to have extremely excellent heat resistance.

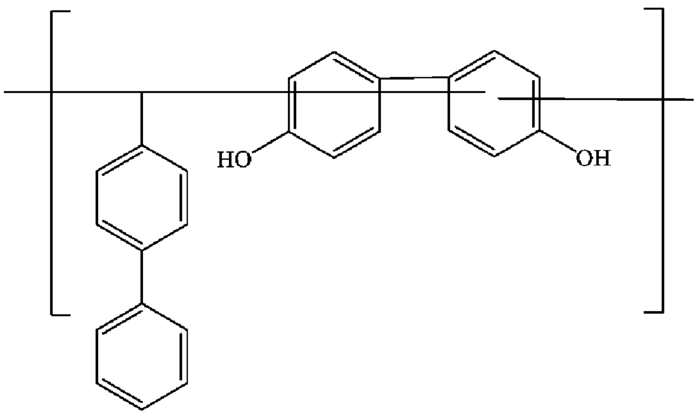

(PBiP−1)

(Synthesis Working Example 2) Synthesis of PBiP-2

A container (internal capacity: 200 mL) equipped with a stirrer, a condenser tube, and a burette was prepared. 4.0 g of the objective compound (PBiP-2) represented by the following formula was obtained by the same operation as in the synthesis working example 1 except that 30 g (161 mmol) of 4,4-biphenol (a reagent manufactured by Tokyo Chemical Industry Co., Ltd.) and 16.2 g (100 mmol) of 4-butylbenzaldehyde (manufactured by Mitsubishi Gas Chemical Company, Inc.) instead of 4-biphenylaldehyde were used in this container.

The following peaks were found by 400 MHz-1H-NMR, and the compound was confirmed to have a chemical structure of the following formula (PBiP-2).

1H-NMR: (d-DMSO, internal standard TMS) δ (ppm) 9.4 (O-H), 6.8-7.8 (Ph-H), 6.3 (C-H) 1.9 (-C4H9)
As a result of GPC analysis of the obtained compound, the weight average molecular weight measured was 4678.

The obtained compound had a decreasing rate of weight of less than 10% under nitrogen at 400°C and was confirmed to have extremely excellent heat resistance.

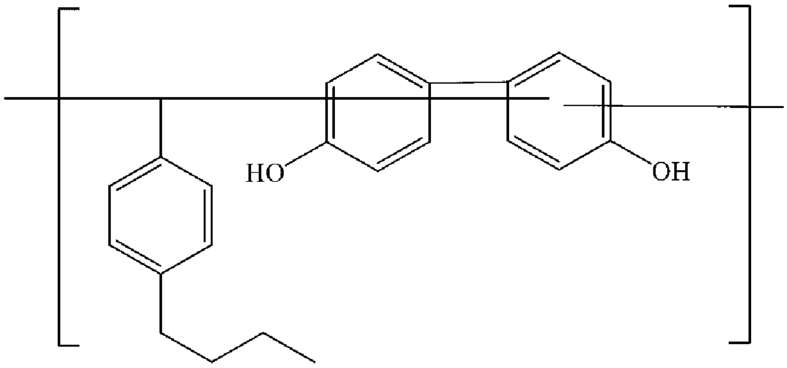

(PBiP-2)

(Synthesis Working Example 3) Synthesis of PODP-1

A container (internal capacity: 200 mL) equipped with a stirrer, a condenser tube, and a burette was prepared. 2.3 g of the objective compound (PODP-1) represented by the following formula was obtained by the same operation as in the synthesis working example 1 except that 30.3 g (150 mmol) of 4,4-dihydroxydiphenyl ether (a reagent manufactured by Tokyo Chemical Industry Co., Ltd.) instead of 4,4-biphenol and 18.2 g (100 mmol) of 4-biphenylaldehyde (manufactured by Mitsubishi Gas Chemical Company, Inc.) were used in this container.

The following peaks were found by 400 MHz-1H-NMR, and the compound was confirmed to have a chemical structure of the following formula (PODP-1).
1H-NMR: (d-DMSO, internal standard TMS) δ (ppm) 9.2 (O-H), 6.5-7.9 (Ph-H), 6.3 (C-H)
As a result of GPC analysis of the obtained compound, the weight average molecular weight measured was 4654.

The obtained compound had a decreasing rate of weight of less than 10% under nitrogen at 400°C and was confirmed to have extremely excellent heat resistance.

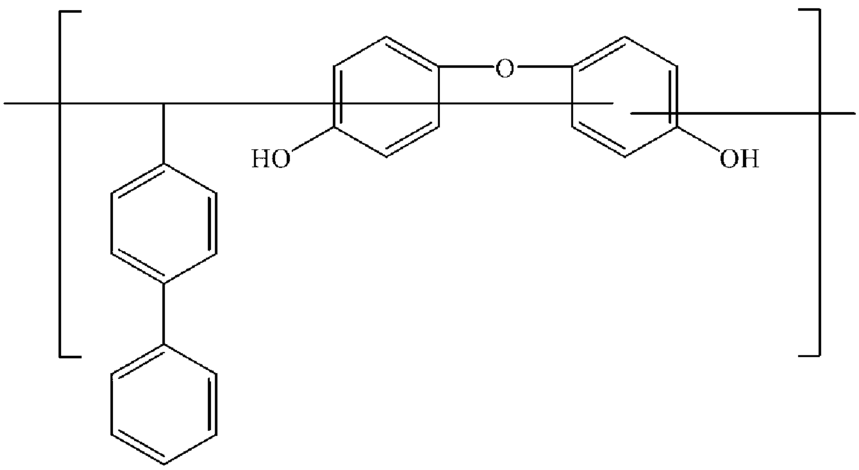

(PODP-1)

(Synthesis Working Example 4) Synthesis of PODP-2

A container (internal capacity: 200 mL) equipped with a stirrer, a condenser tube, and a burette was prepared. 2.3 g of the objective compound (PODP-2) represented by the following formula was obtained by the same operation as in the synthesis working example 1 except that 30.3 g (150 mmol) of 4,4-dihydroxydiphenyl ether (a reagent manufactured by Tokyo Chemical Industry Co., Ltd.) instead of 4,4-biphenol and 16.2 g (100 mmol) of 4-butylbenzaldehyde (manufactured by Mitsubishi Gas Chemical Company, Inc.) instead of 4-biphenylaldehyde were used in this container.

The following peaks were found by 400 MHz-1H-NMR, and the compound was confirmed to have a chemical structure of the following formula (PODP-2).

1H-NMR: (d-DMSO, internal standard TMS) δ (ppm) 9.3 (O-H), 6.5-7.9 (Ph-H), 6.3 (C-H), 1.9 (-C4H9)

As a result of GPC analysis of the obtained compound, the weight average molecular weight measured was 5213.

The obtained compound had a decreasing rate of weight of less than 10% under nitrogen at 400°C and was confirmed to have extremely excellent heat resistance.

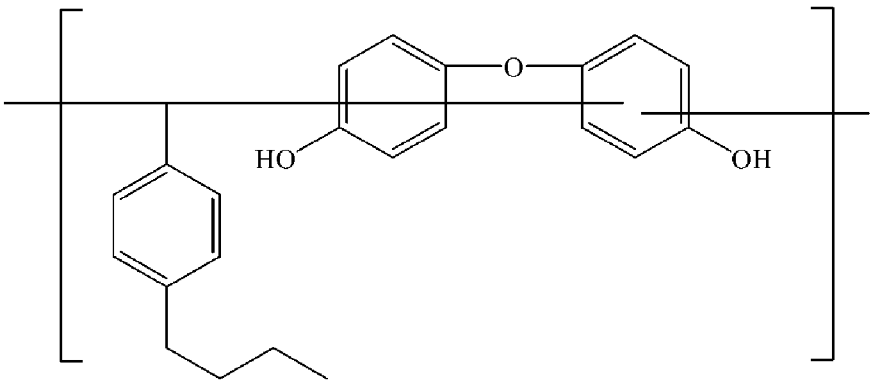

(PODP−2)

(Synthesis Working Example 5) Synthesis of POCBP-1

A container (internal capacity: 200 mL) equipped with a stirrer, a condenser tube, and a burette was prepared. 2.3 g of the objective compound (POCBP-1) represented by the following formula was obtained by the same operation as in the synthesis working example 1 except that 32.1 g (150 mmol) of 3, 3-dimethyl-4,4-biphenol (a reagent manufactured by Tokyo Chemical Industry Co., Ltd.) instead of 4,4-biphenol and 18.2 g (100 mmol) of 4-biphenylaldehyde (manufactured by Mitsubishi Gas Chemical Company, Inc.) were used in this container.

The following peaks were found by 400 MHz-1H-NMR, and the compound was confirmed to have a chemical structure of the following formula (POCBP-1).

1H-NMR: (d-DMSO, internal standard TMS) δ (ppm) 9.3 (O-H), 6.3-7.9 (Ph-H), 6.1 (C-H), 2.3-2.5 (-CH3)

As a result of GPC analysis of the obtained compound, the weight average molecular weight measured was 5213.

The obtained compound had a decreasing rate of weight of less than 10% under nitrogen at 400°C and was confirmed to have extremely excellent heat resistance.

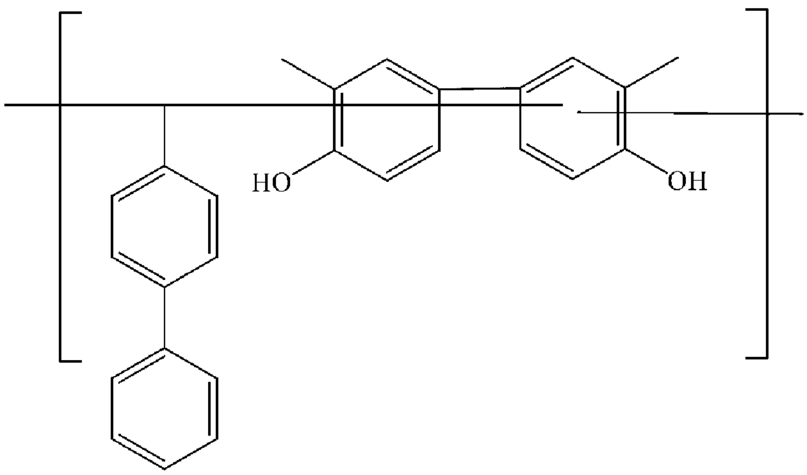

(POCBP−1)

(Synthesis Working Example 6) Synthesis of POCBP-2

A container (internal capacity: 200 mL) equipped with a stirrer, a condenser tube, and a burette was prepared. 3.3 g of the objective compound (POCBP-2) represented by the following formula was obtained by the same operation as in the synthesis working example 1 except that 32.1 g (150 mmol) of 3,3-dimethyl-4,4-biphenol (a reagent manufactured by Tokyo Chemical Industry Co., Ltd.) instead of 4,4-biphenol and 16.2 g (100 mmol) of 4-butylbenzaldehyde (manufactured by Mitsubishi Gas Chemical Company, Inc.) instead of 4-biphenylaldehyde were used in this container.
The following peaks were found by 400 MHz-1H-NMR, and the compound was confirmed to have a chemical structure of the following formula (POCBP-2).
1H-NMR: (d-DMSO, internal standard TMS) δ (ppm) 9.3 (O-H), 6.5-7.9 (Ph-H), 6.2 (C-H), 2.3-2.5 (-CH3), 1.9 (-C4H9)
As a result of GPC analysis of the obtained compound, the weight average molecular weight measured was 4415.
The obtained compound had a decreasing rate of weight of less than 10% under nitrogen at 400°C and was confirmed to have extremely excellent heat resistance.

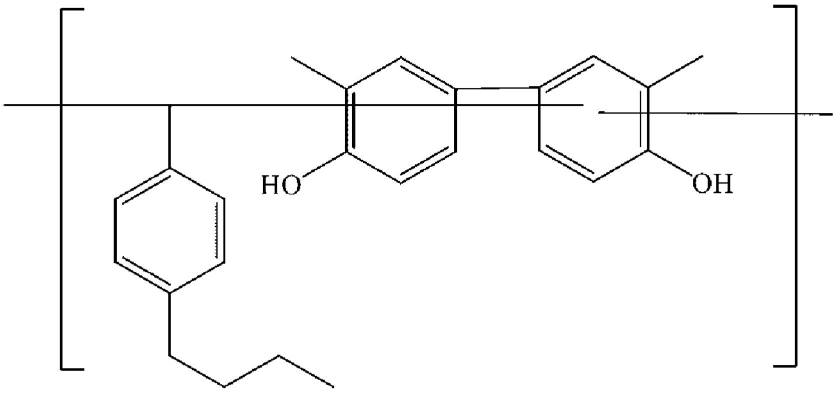

(POCBP-2)

(Synthesis Working Example 7) Synthesis of PDDM-1

A container (internal capacity: 200 mL) equipped with a stirrer, a condenser tube, and a burette was prepared. 3.3 g of the objective compound (PDDM-1) represented by the following formula was obtained by the same operation as in the synthesis working example 1 except that 30.1 g (150 mmol) of 4,4-dihydroxydiphenylmethane (a reagent manufactured by Tokyo Chemical Industry Co., Ltd.) instead of 4,4-biphenol and 18.2 g (100 mmol) of 4-biphenylaldehyde (manufactured by Mitsubishi Gas Chemical Company, Inc.) were used in this container.
The following peaks were found by 400 MHz-1H-NMR, and the compound was confirmed to have a chemical structure of the following formula (PDDM-1).
1H-NMR: (d-DMSO, internal standard TMS) δ (ppm) 9.3 (O-H), 6.5-7.9 (Ph-H), 6.3 (C-H), 4.1 (-CH2-)
As a result of GPC analysis of the obtained compound, the weight average molecular weight measured was 4632.
The obtained compound had a decreasing rate of weight of less than 10% under nitrogen at 400°C and was confirmed to have extremely excellent heat resistance.

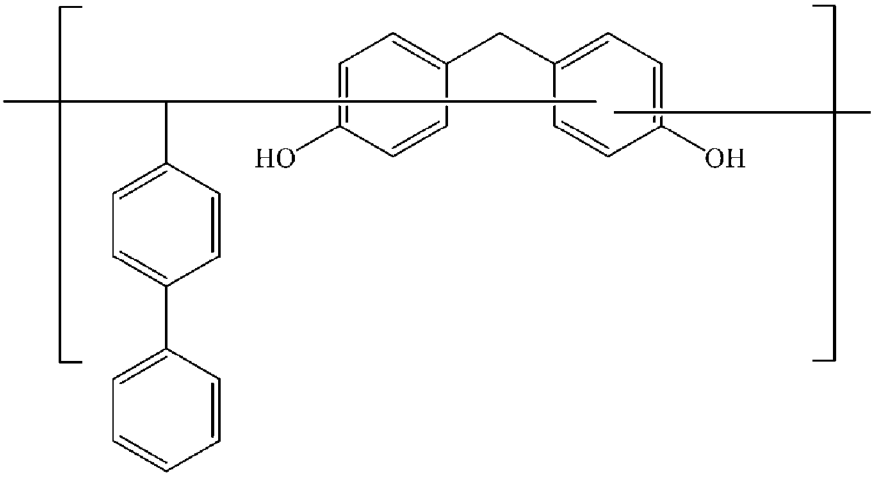

(PDDM-1)

(Synthesis Working Example 8) Synthesis of PDDM-2

A container (internal capacity: 200 mL) equipped with a stirrer, a condenser tube, and a burette was prepared. 4.3 g of the objective compound (PDDM-2) represented by the following formula was obtained by the same operation as in the synthesis working example 1 except that 30.1 g (150 mmol) of 4,4-dihydroxydiphenylmethane (a reagent manufactured by Tokyo Chemical Industry Co., Ltd.) instead of 4,4-biphenol and 16.2 g (100 mmol) of 4-butylbenzaldehyde (manufactured by Mitsubishi Gas Chemical Company, Inc.) instead of 4-biphenylaldehyde were used in this container.

The following peaks were found by 400 MHz-1H-NMR, and the compound was confirmed to have a chemical structure of the following formula (PDDM-2).

1H-NMR: (d-DMSO, internal standard TMS) δ (ppm) 9.3 (O-H), 6.5-7.9 (Ph-H), 6.3 (C-H), 4.0 (-CH2-), 1.8 (-C4H9)

As a result of GPC analysis of the obtained compound, the weight average molecular weight measured was 5143.

The obtained compound had a decreasing rate of weight of less than 10% under nitrogen at 400°C and was confirmed to have extremely excellent heat resistance.

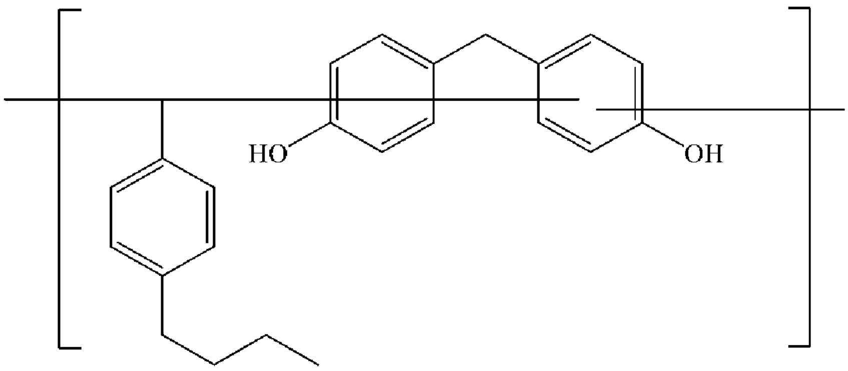

(PDDM-2)

(Synthesis Working Example 9) Synthesis of PDBZ-1

A container (internal capacity: 200 mL) equipped with a stirrer, a condenser tube, and a burette was prepared. 3.5 g of the objective compound (PDBZ-1) represented by the following formula was obtained by the same operation as in the synthesis working example 1 except that 32.1 g (150 mmol) of 4,4-dihydroxybenzophenone (a reagent manufactured by Tokyo Chemical Industry Co., Ltd.) instead of 4,4-biphenol and 18.2 g (100 mmol) of 4-biphenylaldehyde (manufactured by Mitsubishi Gas Chemical Company, Inc.) were used in this container.

The following peaks were found by 400 MHz-1H-NMR, and the compound was confirmed to have a chemical structure of the following formula (PDBZ-1).

1H-NMR: (d-DMSO, internal standard TMS) δ (ppm) 9.4 (O-H), 6.5-7.8 (Ph-H), 6.3 (C-H)

As a result of GPC analysis of the obtained compound, the weight average molecular weight measured was 4754.

The obtained compound had a decreasing rate of weight of less than 10% under nitrogen at 400°C and was confirmed to have extremely excellent heat resistance.

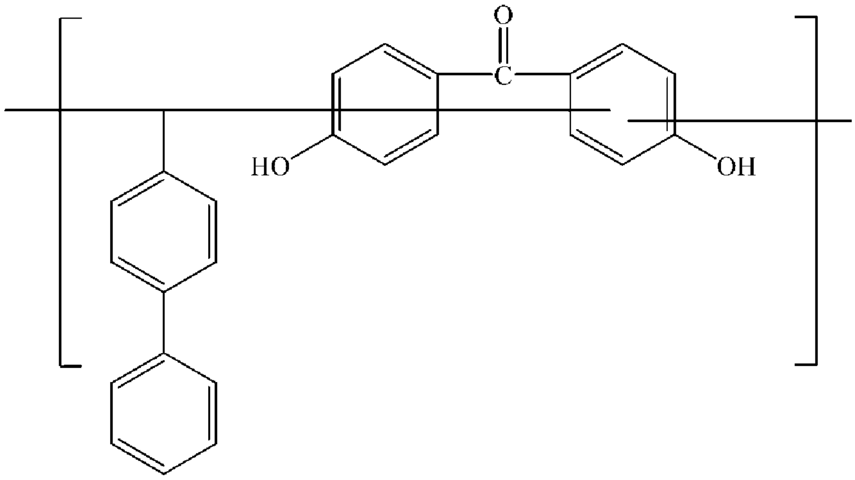

(PDBZ−1)

(Synthesis Working Example 10) Synthesis of PDBZ-2

A container (internal capacity: 200 mL) equipped with a stirrer, a condenser tube, and a burette was prepared. 3.2 g of the objective compound (PDBZ-2) represented by the following formula was obtained by the same operation as in the synthesis working example 1 except that 32.1 g (150 mmol) of 4,4-dihydroxybenzophenone (a reagent manufactured by Tokyo Chemical Industry Co., Ltd.) instead of 4,4-biphenol and 16.2 g (100 mmol) of 4-butylbenzaldehyde (manufactured by Mitsubishi Gas Chemical Company, Inc.) instead of 4-biphenylaldehyde were used in this container.

The following peaks were found by 400 MHz-1H-NMR, and the compound was confirmed to have a chemical structure of the following formula (PDBZ-2).

1H-NMR: (d-DMSO, internal standard TMS) δ (ppm) 9.4 (O-H), 6.4-7.9 (Ph-H), 6.1 (C-H), 1.9 (-C4H9)

As a result of GPC analysis of the obtained compound, the weight average molecular weight measured was 4945.

The obtained compound had a decreasing rate of weight of less than 10% under nitrogen at 400°C and was confirmed to have extremely excellent heat resistance.

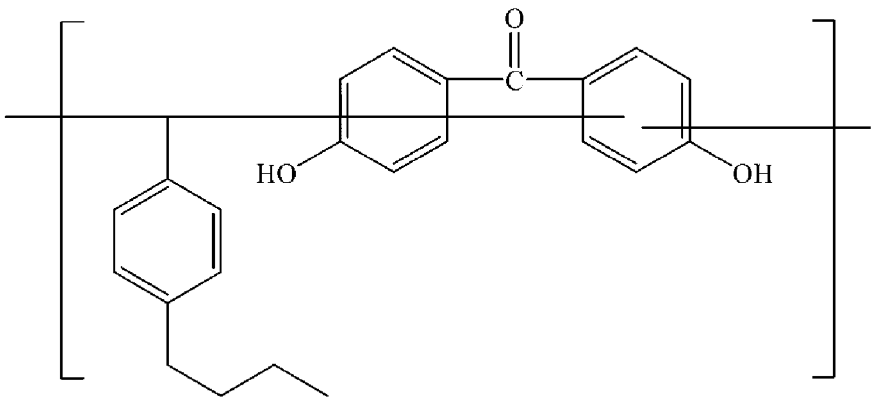

(PDBZ−2)

(Synthesis Working Example 11) Synthesis of PBNF-1

A container (internal capacity: 300 mL) equipped with a stirrer, a condenser tube, and a burette was prepared. 5.3 g of the objective compound (PBNF-1) represented by the following formula was obtained by the same operation as in the synthesis working example 1 except that 42.9 g (150 mmol) of 1, 1-bi-2-naphthol (a reagent manufactured by

Tokyo Chemical Industry Co., Ltd.) instead of 4,4-biphenol and 18.2 g (100 mmol) of 4-biphenylaldehyde (manufactured by Mitsubishi Gas Chemical Company, Inc.) were used in this container.

The following peaks were found by 400 MHz-1H-NMR, and the compound was confirmed to have a chemical structure of the following formula (PBNF-1).

1H-NMR: (d-DMSO, internal standard TMS) δ (ppm) 9.2-9.4 (O-H), 6.2-8.1 (Ph-H), 6.0 (C-H)

As a result of GPC analysis of the obtained compound, the weight average molecular weight measured was 6213.

The obtained compound had a decreasing rate of weight of less than 10% under nitrogen at 400°C and was confirmed to have extremely excellent heat resistance.

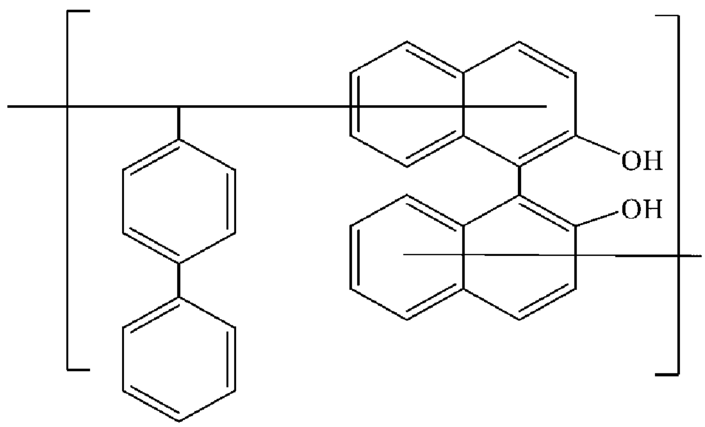

(PBNF－1)

(Synthesis Working Example 12) Synthesis of PBNF-2

A container (internal capacity: 300 mL) equipped with a stirrer, a condenser tube, and a burette was prepared. 4.9 g of the objective compound represented by the following formula (PBNF-2) was obtained by the same operation as in the synthesis working example 1 except that 42.9 g (150 mmol) of 1, 1-bi-2-naphthol (a reagent manufactured by Tokyo Chemical Industry Co., Ltd.) instead of 4,4-biphenol and 16.2 g (100 mmol) of 4-butylbenzaldehyde (manufactured by Mitsubishi Gas Chemical Company, Inc.) instead of 4-biphenylaldehyde were used in this container.

The following peaks were found by 400 MHz-1H-NMR, and the compound was confirmed to have a chemical structure of the following formula (PBNF-2).

1H-NMR: (d-DMSO, internal standard TMS) δ (ppm) 9.1-9.3 (O-H), 6.5-7.9 (Ph-H), 6.1 (C-H), 1.9 (-C4H9)

As a result of GPC analysis of the obtained compound, the weight average molecular weight measured was 4415.

The obtained compound had a decreasing rate of weight of less than 10% under nitrogen at 400°C and was confirmed to have extremely excellent heat resistance.

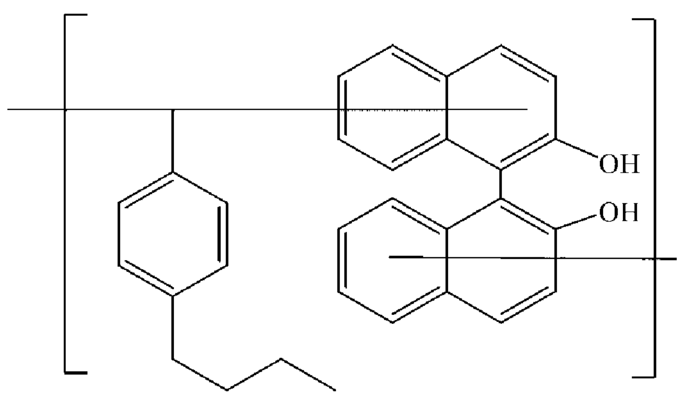

(PBNF－2)

(Synthetic Example 1)

A four necked flask (internal capacity: 10 L) equipped with a Dimroth condenser tube, a thermometer, and a stirring blade and having a detachable bottom was prepared. To this four necked flask, 1.09 kg (7 mol) of 1,5-dimethylnaphthalene (manufactured by Mitsubishi Gas Chemical Company, Inc.), 2.1 kg (28 mol as formaldehyde) of a 40 mass% aqueous formalin solution (manufactured by Mitsubishi Gas Chemical Company, Inc.), and 0.97 mL of a 98 mass% sulfuric acid (manufactured by Kanto Chemical Co., Inc.) were added in a nitrogen stream, and the mixture was reacted for 7 hours while refluxed at 100°C at normal pressure. Subsequently, 1.8 kg of ethylbenzene (special grade reagent manufactured by Wako Pure Chemical Industries, Ltd.) was added as a diluting solvent to the reaction liquid, and the mixture was left to stand still, followed by removal of an aqueous phase as a lower phase. Neutralization and washing with water were further performed, and ethylbenzene and unreacted 1,5-dimethylnaphthalene were distilled off under reduced pressure to obtain 1.25 kg of a dimethylnaphthalene formaldehyde resin as a light brown solid. The number average molecular weight (Mn) of the obtained dimethylnaphthalene formaldehyde resin was 562, the weight average molecular weight thereof (Mw) was 1168, and the dispersity thereof (Mw/Mn) was 2.08.

Then, a four necked flask (internal capacity: 0.5 L) equipped with a Dimroth condenser tube, a thermometer, and a stirring blade was prepared. To this four necked flask, 100 g (0.51 mol) of the dimethylnaphthalene formaldehyde resin obtained as described above, and 0.05 g of p-toluenesulfonic acid were added in a nitrogen stream, and the temperature was raised to 190°C at which the mixture was then heated for 2 hours, followed by stirring. Subsequently, 52.0 g (0.36 mol) of 1-naphthol was further added thereto, the temperature was further elevated to 220°C, and the mixture was reacted for 2 hours. After dilution with a solvent, neutralization and washing with water were performed, and the solvent was distilled off under reduced pressure to obtain 126.1 g of a modified resin (CR-1) as a black-brown solid.

The obtained resin (CR-1) had Mn: 885, Mw: 2220, and Mw/Mn: 2.51. In addition, the carbon concentration of the obtained resin (CR-1) was 89.1% by mass, and the oxygen concentration thereof was 4.5% by mass. Note that the Mn, Mw and Mw/Mn of the resin (CR-1) were determined by gel permeation chromatography (GPC) analysis under the following measurement conditions in terms of polystyrene.

Apparatus: Shodex GPC-101 model (a product manufactured by Showa Denko K.K.)
Column: KF-80M × 3
Eluent: 1 mL/min THF
Temperature: 40°C

[Examples 1 to 12 and Comparative Example 1]

Solubility test was conducted in various organic solvent at 23°C for the compounds obtained by the above Synthesis Working Examples (PBiP-1 to PBNF-2) and CR-1. (Organic solvents) Propylene glycol monomethyl ether acetate (in the table, designated as "PGMEA"), propylene glycol monomethyl ether (in the table, designated as "PGME"), cyclohexanone (in the table, designated as "CHN"), cyclopentanone (in the table, designated as "CPN"), and ethyl lactate (in the table, designated as "EL"). The results are shown in Table 1.

[Solubility test]

<Evaluation criteria>

A: Dissolves at 20% by weight or more in the organic solvent.
B: Dissolves at 10% by weight or more and less than 20% by weight in the organic solvent.
C: The solubility in the organic solvent is less than 10% by weight.

[Table 1]

| | Compound or resin | Solubility | | | | |
|---|---|---|---|---|---|---|
| | | PGMEA | PGME | CHN | CPN | EL |
| Example 1 | PBiP-1 | A | A | A | A | A |
| Example 2 | PBiP-2 | A | A | A | A | A |
| Example 3 | PODP-1 | A | A | A | A | A |

(continued)

| | Compound or resin | Solubility | | | | |
|---|---|---|---|---|---|---|
| | | PGMEA | PGME | CHN | CPN | EL |
| Example 4 | PODP-2 | A | A | A | A | A |
| Example 5 | POCBP-1 | A | A | A | A | A |
| Example 6 | POCBP-2 | A | A | A | A | A |
| Example 7 | PDDM-1 | A | A | A | A | A |
| Example 8 | PDDM-2 | A | A | A | A | A |
| Example 9 | PDBZ-1 | A | A | A | A | A |
| Example 10 | PDBZ-2 | B | A | A | A | B |
| Example 11 | PBNF-1 | B | A | A | A | B |
| Example 12 | PBNF-2 | B | A | A | A | B |
| Comparative Example 1 | CR-1 | A | A | B | B | C |

As shown in Table 1, the compounds obtained by the Synthesis Working Examples (PBiP-1 to PBNF-2) were confirmed to be excellent in solubility in various organic solvent.

Subsequently, each composition for film formation for lithography corresponding to Examples 13 to 34 and Comparative Examples 2 and 3 was prepared using the film forming materials for lithography of the present embodiment according to the composition shown in Table 2. The following acid generating agent, crosslinking agent, and organic solvent were used.

Acid generating agent: a product manufactured by Midori Kagaku Co., Ltd., "di-tertiary butyl diphenyliodonium nonafluoromethanesulfonate" (in the table, designated as "DTDPI")

Crosslinking agent: a product manufactured by Sanwa Chemical Co., Ltd., "NIKALAC MX270" (in the table, designated as "NIKALAC")

Organic solvent: Propylene glycol monomethyl ether acetate (in the table, designated as "PGMEA")

Then, a silicon supporting material was spin coated with each of the compositions for film formation for lithography of Examples 13 to 34 and Comparative Examples 2 and 3, and the film thickness after pre-baking at 150°C for 60 seconds was measured and taken as the initial film thickness. Thereafter, post-baking was performed under a nitrogen atmosphere at 450°C for 120 seconds, and the film thickness of the coating film was measured. From the difference between the initial film thickness and the film thickness after the post-baking, the decreasing rate of film thickness (%) was calculated to evaluate the film heat resistance of each underlayer film under the conditions shown below.

Thereafter, the silicon supporting material was immersed in a mixed solvent of 70% PGMEA/30% PGME for 60 seconds, the solvent attached was removed with Aero-Duster, and then, the solvent was dried at 110°C. From the difference in film thickness before and after the immersion, the decreasing rate of film thickness (%) was calculated to evaluate the setting properties of each underlayer film under the conditions shown below.

In addition, the flatness of a film formed on a supporting material having difference in level was evaluated under the conditions shown below.

[Evaluation of film heat resistance]

<Evaluation criteria>

S: Decreasing rate of film thickness before and after baking at 450°C ≤ 20%
A: Decreasing rate of film thickness before and after baking at 450°C ≤ 25%
B: Decreasing rate of film thickness before and after baking at 450°C ≤ 30%
C: Decreasing rate of film thickness before and after baking at 450°C > 30%

[Evaluation of setting properties]

<Evaluation criteria>

S: Decreasing rate of film thickness before and after solvent immersion ≤ 1%
A: Decreasing rate of film thickness before and after solvent immersion ≤ 5%
B: Decreasing rate of film thickness before and after solvent immersion ≤ 10%
C: Decreasing rate of film thickness before and after solvent immersion > 10%

[Evaluation of flatness]

Onto a $SiO_2$ supporting material having difference in level on which trenches with a width of 100 nm, a pitch of 150 nm and a depth of 150 nm (aspect ratio: 1.5) and trenches with a width of 5 μm and a depth of 180 nm (open space) were mixedly present, each of the obtained compositions for film formation was coated. Subsequently, it was calcined at 450°C for 120 seconds under a nitrogen atmosphere to form a resist underlayer film having a film thickness of 200 nm. The shape of this resist underlayer film was observed with a scanning electron microscope ("S-4800" from Hitachi High-Technologies Corporation), and the difference between the maximum value and the minimum value of the film thickness of the resist underlayer film on the trench or space (ΔFT) was measured.

<Evaluation criteria>

S: ΔFT < 15 nm (best flatness)
A: 15 nm ≤ ΔFT < 20 nm (good flatness)
B: 20 nm ≤ ΔFT < 40 nm (partially good flatness)
C: 40 nm ≤ ΔFT (poor flatness)

For each of the obtained underlayer films obtained in Examples 13 to 34 and Comparative Examples 2 and 3, etching test was carried out under the following conditions to evaluate etching resistance. The evaluation results are shown in Table 2.

[Etching test]

Etching apparatus: a product manufactured by Samco International, Inc., "RIE-10NR"
Output: 50 W
Pressure: 20 Pa
Time: 2 min
Etching gas
Ar gas flow rate: $CF_4$ gas flow rate:$O_2$ gas flow rate = 50:5:5 (seem)

[Evaluation of etching resistance]

The evaluation of etching resistance was carried out by the following procedures.

First, an underlayer film containing a phenol novolac resin was prepared under the same conditions as in Example 13 except that a phenol novolac resin (PSM4357 manufactured by Gunei Chemical Industry Co., Ltd.) was used instead of the compound (PBiP-1) used in Example 13. Then, the above etching test was carried out for this underlayer film containing a phenol novolac resin, and the etching rate (etching speed) was measured. Next, for each of the underlayer films of Examples and Comparative Example, the above etching test was carried out, and the etching rate was measured. Then, the etching resistance for each of Examples and Comparative Example was evaluated according to the following evaluation criteria on the basis of the etching rate of the underlayer film containing a phenol novolac resin.

[Evaluation criteria]

A: The etching rate was less than -10% as compared with the underlayer film of novolac.

B: The etching rate was -10% to +5% as compared with the underlayer film of novolac.

C: The etching rate was more than +5% as compared with the underlayer film of novolac.

[Table 2-1]

| | Resin (parts by mass) | Solvent (parts by mass) | Acid generating agent (parts by mass) | Crosslinking agent (parts by mass) | Film heat resistance | Setting properties | Flatness | Etching resistance |
|---|---|---|---|---|---|---|---|---|
| Example 13 | PBiP-1 (10) | PGMEA (90) | - | - | A | A | A | A |
| Example 14 | PBiP-1 (10) | PGMEA (90) | DTDPI (1.0) | NIKALAC (0.5) | A | A | A | B |
| Example 15 | PBiP-2 (10) | PGMEA (90) | - | - | A | A | A | A |
| Example 16 | PBiP-2 (10) | PGMEA (90) | DTDPI (1.0) | NIKALAC (0.5) | A | A | A | B |
| Example 17 | PODP-1 (10) | PGMEA (90) | - | - | A | A | S | A |
| Example 18 | PODP-1 (10) | PGMEA (90) | DTDPI (1.0) | NIKALAC (0.5) | A | A | S | B |
| Example 19 | PODP-2 (10) | PGMEA (90) | - | - | A | A | S | A |
| Example 20 | PODP-2 (10) | PGMEA (90) | DTDPI (1.0) | NIKALAC (0.5) | A | A | S | B |
| Example 21 | POCBP-1 (10) | PGMEA (90) | - | - | A | A | S | A |
| Example 22 | POCBP-1 (10) | PGMEA (90) | DTDPI (1.0) | NIKALAC (0.5) | A | A | S | B |
| Example 23 | POCBP-2 (10) | PGMEA (90) | - | - | A | A | S | A |
| Example 24 | POCBP-2 (10) | PGMEA (90) | DTDPI (1.0) | NIKALAC (0.5) | A | A | S | B |
| Example 25 | PDDM-1 (10) | PGMEA (90) | - | - | A | A | S | A |
| Example 26 | PDDM-1 (10) | PGMEA (90) | DTDPI (1.0) | NIKALAC (0.5) | A | A | S | B |

(continued)

| | Resin (parts by mass) | Solvent (parts by mass) | Acid generating agent (parts by mass) | Crosslinking agent (parts by mass) | Film heat resistance | Setting properties | Flatness | Etching resistance |
|---|---|---|---|---|---|---|---|---|
| Example 27 | PDDM-2 (10) | PGMEA (90) | - | - | A | A | S | A |
| Example 28 | PDDM-2 (10) | PGMEA (90) | DTDPI (1.0) | NIKALAC (0.5) | A | A | S | B |

[Table 2-2]

| | | | | | | | | |
|---|---|---|---|---|---|---|---|---|
| Example 29 | PDBZ-1 (10) | PGMEA (90) | - | - | A | A | S | A |
| Example 30 | PDBZ-1 (10) | PGMEA (90) | DTDPI (1.0) | NIKALAC (0.5) | A | A | S | B |
| Example 31 | PDBZ-2 (10) | PGMEA (90) | - | - | A | A | S | A |
| Example 32 | PDBZ-2 (10) | PGMEA (90) | DTDPI (1.0) | NIKALAC (0.5) | A | A | S | B |
| Example 33 | PBNF-1 (10) | PGMEA (90) | - | - | S | A | A | A |
| Example 34 | PBNF-1 (10) | PGMEA (90) | DTDPI (1.0) | NIKALAC (0.5) | S | A | A | B |
| Comparative Example 2 | CR-1 (10) | PGMEA (90) | | | C | C | C | C |
| Comparative Example 3 | CR-1 (10) | PGMEA (90) | DTDPI (0.5) | NIKALAC (0.5) | C | C | B | C |

As is evident from Table 2, Examples 13 to 34 using the compound of the present embodiment were confirmed to be good in terms of any of film heat resistance, setting properties, film flatness, and etching resistance. On the other hand, Comparative Example 2 or 3 using CR-1 (phenol-modified dimethylnaphthalene formaldehyde resin) resulted in poor film heat resistance and etching resistance, in particular.

[Examples 35 to 38]

A $SiO_2$ supporting material with a film thickness of 300 nm was coated with the solution of the underlayer film forming material for lithography prepared in each of the above Examples 13 to 16 and baked at 150°C for 60 seconds, and further, under a nitrogen atmosphere, at 450°C for 120 seconds to form each underlayer film with a film thickness of 180 nm. This underlayer film was coated with a resist solution for ArF and baked at 130°C for 60 seconds to form a photoresist layer with a film thickness of 140 nm. The ArF resist solution used was prepared by compounding 5 parts by mass of a compound represented by the formula (11) given below, 1 part by mass of triphenylsulfonium nonafluoromethanesulfonate, 2 parts by mass of tributylamine, and 92 parts by mass of PGMEA. For the compound represented by the formula (11) given below, 4.15 g of 2-methyl-2-methacryloyloxyadamantane, 3.00 g of methacryloyloxy-γ-butyrolactone, 2.08 g of 3-hydroxy-1-adamantyl methacrylate, and 0.38 g of azobisisobutyronitrile were dissolved in 80 mL of tetrahydrofuran to prepare a reaction solution. This reaction solution was polymerized for 22 hours with the reaction temperature kept at 63°C in a nitrogen atmosphere. Then, the reaction solution was added dropwise into 400 mL of n-hexane. The product resin thus obtained was solidified and purified, and the resulting white powder was filtered and dried overnight at 40°C under reduced pressure to obtain a compound represented by the following formula.

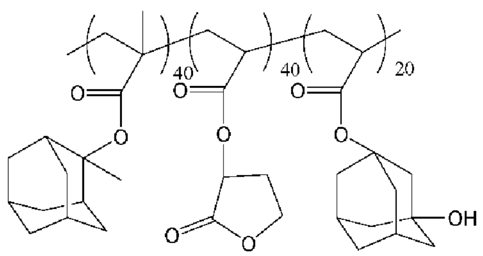

(11)

The numbers in the above formula (11) indicate the ratio of each constitutional unit.

Subsequently, the photoresist layer was exposed using an electron beam lithography system (manufactured by ELIONIX INC.; ELS-7500, 50 keV), baked (PEB) at 115°C for 90 seconds, and developed for 60 seconds in a 2.38 mass% tetramethylammonium hydroxide (TMAH) aqueous solution to obtain a positive type resist pattern.

Defects of the obtained resist patterns of 55 nm L/S (1:1) and 80 nm L/S (1:1) were observed, and the results are shown in Table 3. In the table, "good" means that no major defects were found in the formed resist pattern, and "poor" means that major defects were found in the formed resist pattern.

[Comparative Example 4]

The same operations as in Example 35 were performed except that no underlayer film was formed so that a photoresist layer was formed directly on a $SiO_2$ supporting material to obtain a positive type resist pattern. The results

are shown in Table 3.

[Table 3]

| | Underlayer film forming material | Resolution (nmL/S) | Sensitivity ($\mu C/cm^2$) | Resist pattern shape after development |
|---|---|---|---|---|
| Example 35 | Example 13 | 55 | 10 | Good |
| Example 36 | Example 14 | 60 | 10 | Good |
| Example 37 | Example 15 | 55 | 10 | Good |
| Example 38 | Example 16 | 60 | 10 | Good |
| Comparativ e Example 4 | - | 80 | 26 | Poor |

As is evident from Table 3, Examples 35 to 38 using the compound of the present embodiment were confirmed to be good in terms of the resist pattern shape after development without noticeable defects. Furthermore, each of Examples 35 to 38 was confirmed to be significantly superior to Comparative Example 4, in which no underlayer film was formed, in both resolution and sensitivity. Here, a good resist pattern shape after development indicates that the underlayer film forming materials for lithography used in Examples 35 to 38 have good adhesiveness to a resist material (photoresist material and the like).

[Examples 39 to 42]

A $SiO_2$ supporting material with a film thickness of 300 nm was coated with the solution of the underlayer film forming material for lithography according to each of Examples 13 to 16, and baked at 150°C for 60 seconds and further, under a nitrogen atmosphere, at 450°C for 120 seconds to form each underlayer film with a film thickness of 180 nm. This underlayer film was coated with a silicon-containing intermediate layer material and baked at 200°C for 60 seconds to form an intermediate layer film with a film thickness of 35 nm. This intermediate layer film was further coated with the above resist solution for ArF and baked at 130°C for 60 seconds to form a photoresist layer with a film thickness of 150 nm. The silicon-containing intermediate layer material used was the silicon atom-containing polymer described in <Synthesis Example 1> of Japanese Patent Laid-Open No. 2007-226170. Subsequently, the photoresist layer was mask exposed using an electron beam lithography system (manufactured by ELIONIX INC.; ELS-7500, 50 keV), baked (PEB) at 115°C for 90 seconds, and developed for 60 seconds in a 2.38 mass% tetramethylammonium hydroxide (TMAH) aqueous solution to obtain a 55 nm L/S (1:1) positive type resist pattern. Then, the silicon-containing intermediate layer film (SOG) was dry etched with the obtained resist pattern as a mask using RIE-10NR manufactured by Samco International, Inc. Subsequently, dry etching of the underlayer film with the obtained silicon-containing intermediate layer film pattern as a mask and dry etching of the $SiO_2$ film with the obtained underlayer film pattern as a mask were performed in order.

Respective etching conditions are as shown below.
Conditions for etching of resist intermediate layer film with resist pattern
Output: 50 W
Pressure: 20 Pa
Time: 1 min
Etching gas
Ar gas flow rate: $CF_4$ gas flow rate:$O_2$ gas flow rate = 50:8:2 (seem)
Conditions for etching of resist underlayer film with resist intermediate film pattern
Output: 50 W
Pressure: 20 Pa
Time: 2 min
Etching gas
Ar gas flow rate: $CF_4$ gas flow rate:$O_2$ gas flow rate = 50:5:5 (seem)
Conditions for etching of $SiO_2$ film with resist underlayer film pattern
Output: 50 W
Pressure: 20 Pa
Time: 2 min
Etching gas

Ar gas flow rate: $C_5F_{12}$ gas flow rate:$C_2F_6$ gas flow rate:$O_2$ gas flow rate = 50:4:3:1 (seem)

[Evaluation]

The pattern cross section (that is, the shape of the $SiO_2$ film after etching) obtained as described above was observed by using a product manufactured by Hitachi, Ltd., "electron microscope (S-4800)". The observation results are shown in Table 4. In the table, "good" means that no major defects were found in the formed pattern cross section, and "poor" means that major defects were found in the formed pattern cross section.

[Table 4]

| | Underlayer film forming material | Shape of $SiO_2$ film | Appearance |
|---|---|---|---|
| Example 39 | Example 13 | Rectangle | Good |
| Example 40 | Example 14 | Rectangle | Good |
| Example 41 | Example 15 | Rectangle | Good |
| Example 42 | Example 16 | Rectangle | Good |

Industrial Applicability

The underlayer film forming composition of the present invention has high heat resistance, has high solvent solubility, and is applicable to a wet process.

## Claims

1. An underlayer film forming composition comprising:

a compound having a constituent unit represented by the following formula (1), and
a solvent, wherein
a weight average molecular weight of the compound is 1,000 to 30,000 as a molecular weight in terms of polystyrene, and
a solubility of the compound in propylene glycol monomethyl ether acetate is 10% by mass or more at 23°C:

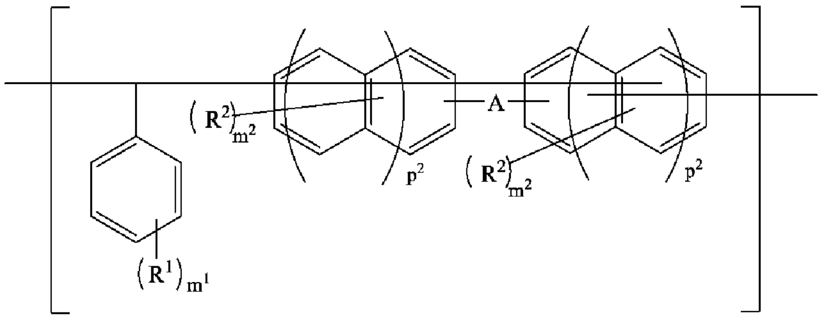

(1)

wherein
A is a single bond or a divalent group,
each $R^1$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group;
each $R^2$ is independently a linear, branched, or cyclic alkyl group having 1 to 10 carbon atoms, an aryl group having 6 to 10 carbon atoms, an alkenyl group having 2 to 10 carbon atoms, an alkynyl group having 2 to 10 carbon atoms, a thiol group, or a hydroxy group,
where at least one $R^2$ is a hydroxy group and/or a thiol group;
each $m^1$ is independently an integer of 0 to 5;

each $m^2$ is independently an integer of 0 to 8; and each $p^2$ is independently an integer of 0 to 2.

**2.** The underlayer film forming composition according to claim 1, wherein the compound having a constituent unit represented by the formula (1) is a compound having a constituent unit represented by the following formula (1a) :

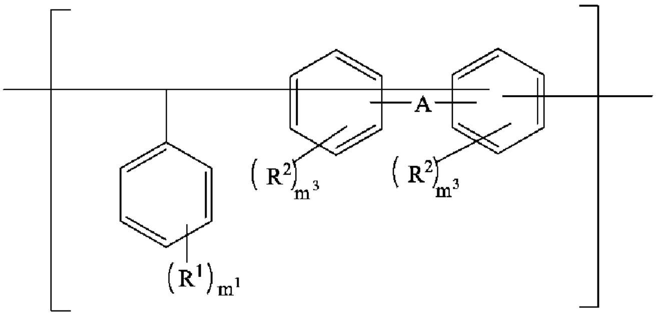

(1 a)

wherein
each $m^3$ is independently an integer of 0 to 4; and
A, $R^1$, $R^2$, and $m^1$ are as defined above.

**3.** The underlayer film forming composition according to claim 2, wherein the compound having a constituent unit represented by the formula (1a) is a compound having a constituent unit represented by the following formula (1b) :

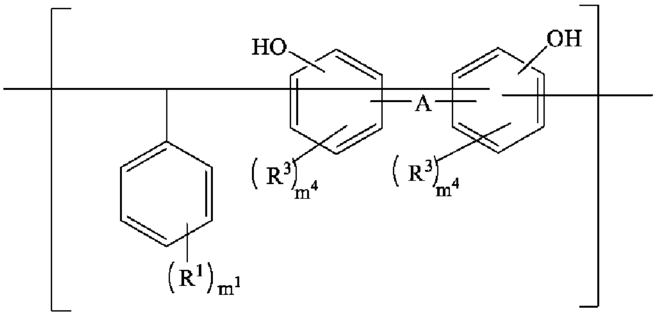

(1 b)

wherein
each $R^3$ is independently a linear, branched, or cyclic alkyl group having 1 to 10 carbon atoms, an aryl group having 6 to 10 carbon atoms, an alkenyl group having 2 to 10 carbon atoms, or an alkynyl group having 2 to 10 carbon atoms;
each $m^4$ is independently an integer of 0 to 3; and
A, $R^1$, and $m^1$ are as defined above.

**4.** The underlayer film forming composition according to any one of claims 1 to 3, wherein A is -S-, -O-, a linear, branched, or cyclic alkylene group having 1 to 10 carbon atoms, an arylene group having 6 to 10 carbon atoms, an alkenylene group having 2 to 10 carbon atoms, an alkynylene group having 2 to 10 carbon atoms, or a carbonyl group.

**5.** The underlayer film forming composition according to any one of claims 1 to 3, wherein A is -O-, a linear, branched, or cyclic alkylene group having 1 to 10 carbon atoms, or a carbonyl group.

**6.** The underlayer film forming composition according to claim 3, wherein the compound having a constituent unit represented by the formula (1b) is a compound having a constituent unit selected from the following formulae (1b-1) to (1b-5) :

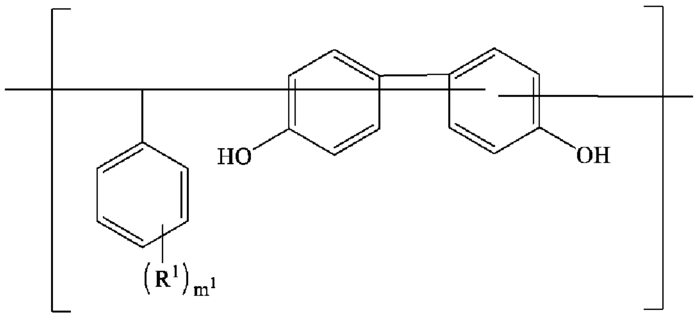

(1 b－1)

wherein $R^1$ and $m^1$ are as defined above;

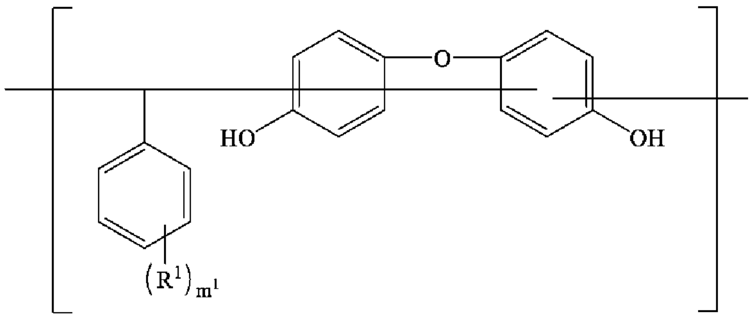

(1 b－2)

wherein $R^1$ and $m^1$ are as defined above;

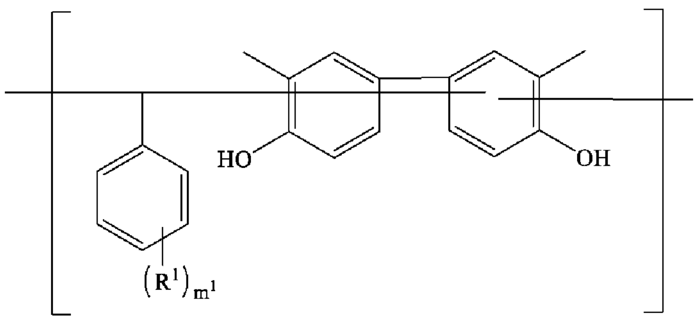

(1 b－3)

wherein $R^1$ and $m^1$ are as defined above;

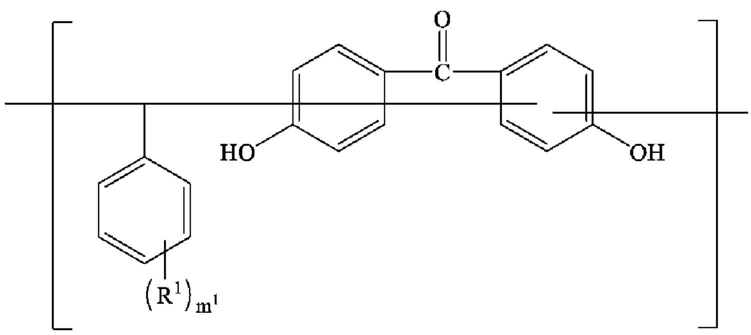

(1 b－4)

wherein $R^1$ and $m^1$ are as defined above; and

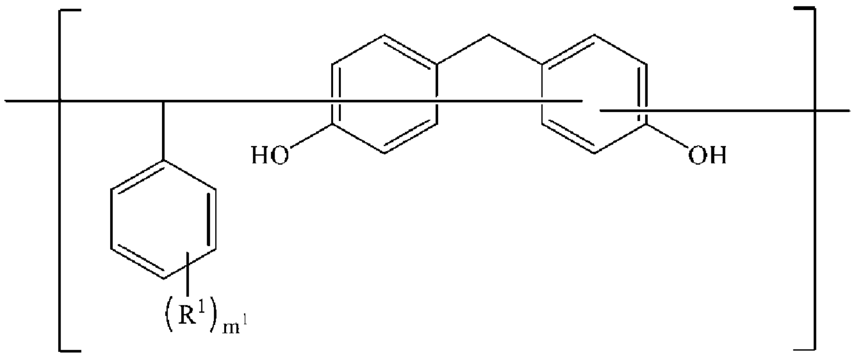

(1 b − 5)

wherein $R^1$ and $m^1$ are as defined above.

7. The underlayer film forming composition according to any one of claims 1 to 6, further comprising an acid generating agent.

8. The underlayer film forming composition according to any one of claims 1 to 7, further comprising a crosslinking agent.

9. An underlayer film for lithography formed from the underlayer film forming composition according to any one of claims 1 to 8.

10. A method for forming a resist pattern, comprising the steps of:

forming an underlayer film on a supporting material using the underlayer film forming composition according to any one of claims 1 to 8;
forming at least one photoresist layer on the underlayer film; and
irradiating a predetermined region of the photoresist layer with radiation for development.

11. A method for forming a circuit pattern, comprising the steps of:

forming an underlayer film on a supporting material using the underlayer film forming composition according to any one of claims 1 to 8;
forming an intermediate layer film on the underlayer film;
forming at least one photoresist layer on the intermediate layer film;
irradiating a predetermined region of the photoresist layer with radiation for development, thereby forming a resist pattern;
etching the intermediate layer film with the resist pattern as a mask;
etching the underlayer film with the obtained intermediate layer film pattern as a mask; and
etching the supporting material with the obtained underlayer film pattern as a mask, thereby forming a pattern on the supporting material.

12. A resist permanent film formed from the underlayer film forming composition according to any one of claims 1 to 8.

**INTERNATIONAL SEARCH REPORT**

International application No.
PCT/JP2019/028741

A. CLASSIFICATION OF SUBJECT MATTER
Int.Cl. G03F7/11(2006.01)i, C08G8/04(2006.01)i, G03F7/20(2006.01)i, G03F7/039(2006.01)n
According to International Patent Classification (IPC) or to both national classification and IPC

B. FIELDS SEARCHED
Minimum documentation searched (classification system followed by classification symbols)
Int.Cl. G03F7/11, C08G8/04, G03F7/20, G03F7/039

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | WO 2016/143635 A1 (MITSUBISHI GAS CHEMICAL CO., INC.) 15 September 2016, claims, examples, paragraph [0223] & US 2018/0044270 A1, claims, examples, paragraph [0330] & EP 3266759 A1 & CN 107531597 A & KR 10-2017-0127489 A & SG 11201706524W A & TW 201638061 A | 1-3, 6-12<br>4-5 |
| X<br>A | WO 2018/056277 A1 (MITSUBISHI GAS CHEMICAL CO., INC.) 29 March 2018, claims, example 9, paragraph [0294] & CN 109790097 A & KR 10-2019-0057060 A & TW 201827389 A | 1-3, 6-12<br>4-5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 01 October 2019 (01.10.2019) | 08 October 2019 (08.10.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/028741

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2013-156627 A (SHIN-ETSU CHEMICAL CO., LTD.) 15 August 2013, claims, examples & US 2013/0171569 A1, claims, examples & KR 10-2013-0080457 A & TW 201348884 A | 1-2, 4-5, 7-11<br>3, 6, 12 |
| X<br>A | JP 2016-044241 A (SHIN-ETSU CHEMICAL CO., LTD.) 04 April 2016, claims, example 5 & US 2016/0056047 A1, claims, example 5 & KR 10-2016-0023564 A & TW 201612197 A | 1-4, 7-11<br>5-6, 12 |
| X<br>A | WO 2014/024836 A1 (NISSAN CHEMICAL INDUSTRIES, LTD.) 13 February 2014, claims, examples, [formula 7] (1-29) & US 2015/0212418 A1, claims, examples, paragraph [0035] (1-29) & CN 104508558 A & KR 10-2015-0043380 A & TW 201413394 A | 1-5, 7-11<br>6, 12 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004271838 A
- JP 2005250434 A
- WO 2013024779 A
- WO 2018016614 A
- JP 2002334869 A
- WO 2004066377 A
- JP 2007226170 A
- JP 2007226204 A